# DEMANDE DE BREVET EUROPEEN

(11) **EP 3 633 677 A1**
(43) Date de publication de la demande: **08.04.2020**
(21) Numéro de dépôt: 19200690.6
(22) Date de dépôt: 01.10.2019
(51) Int. Cl.: G11C 15/04, G11C 11/419, G11C 7/10

(54) **CIRCUIT MEMOIRE IMC A CELLULES 6T**

(30) Priorité: 01.10.2018 FR 1859075
(71) Demandeur: Commissariat à l'énergie atomique et aux énergies alternatives, 75015 Paris (FR)
(72) Inventeur: MAKOSIEJ, Adam, 38054 GRENOBLE CEDEX 09 (FR)
(74) Mandataire: Brevalex

(57) **Abrégé**

Circuit mémoire pour mettre en œuvre des opérations logiques et doté de cellules mémoires, en particulier de structure 6T, avec un circuit de commande configuré pour activer les premiers transistors d'accès ou les deuxièmes transistors d'accès d'au moins deux cellules d'une même colonne donnée et pour détecter à partir d'une ligne d'alimentation basse ou haute, de ladite colonne donnée, distincte des lignes de bits, un signal représentatif du résultat d'une opération logique ayant pour opérandes des données stockées dans lesdites au moins deux cellules.

## Description

### DOMAINE TECHNIQUE ET ART ANTÉRIEUR

La présente demande se rapporte au domaine des dispositifs de calcul en mémoire (en anglais « In Memory Computing »), c'est-à-dire des dispositifs dotés d'un circuit mémoire adapté pour mettre en œuvre des opérations de calculs.

De façon classique un dispositif de calcul numérique tel que par exemple un microprocesseur est doté d'une mémoire interne et d'une unité arithmétique et logique (ALU) adaptée à la mise en œuvre des opérations arithmétiques et/ou logiques de base pour traiter des données contenues dans la mémoire interne.

Pour permettre d'augmenter la vitesse de certains traitements de données et/ou limiter la consommation énergétique liée à ces traitements, des circuits mémoires configurés pour réaliser des opérations de calculs, en particulier des opérations logiques, sont apparus.

Le document FR 3 051960 A1 prévoit par exemple un circuit mémoire avec des cellules SRAM à 10 transistors agencées en lignes et en colonnes, les cellules d'une même ligne partageant 3 lignes de mots, tandis que les cellules d'une même colonne sont couplées à 4 lignes de bits. Ce circuit mémoire est doté :
- d'un étage de commande pour activer simultanément une paire de cellules d'une même colonne,
- d'un étage de lecture pour lire une valeur représentative d'une opération logique ayant pour opérandes des données stockées dans les cellules. L'étage de lecture est ici connecté aux lignes de bits comme pour une lecture en mode SRAM classique.

Le document US 6 552 924 B1 présente quant à lui un circuit mémoire avec des cellules à 4 transistors et qui est adapté à mettre en œuvre des opérations logiques. La lecture d'une valeur représentative d'une opération logique est ici réalisée à partir d'une seule des lignes de sélection de colonne ou de rangée. Un inconvénient majeur de ce circuit est que la lecture, ainsi que d'autres opérations, nécessitent de déséquilibrer le point mémoire en appliquant des potentiels d'alimentation différents sur les deux colonnes ou les deux rangées. Un tel déséquilibre de tensions peut aisément entraîner des basculements inopinés d'état d'une cellule mémoire lors de son activation en lecture, et un tel circuit est ainsi inutilisable pour des applications basse tension.

Il se pose le problème de trouver un nouveau dispositif de mémoire adapté pour réaliser des opérations logiques et présentant des améliorations en termes de consommation et/ou d'encombrement.

### EXPOSÉ DE L'INVENTION

Selon un aspect, la présente demande vise à protéger un circuit mémoire adapté à mettre en œuvre des opérations de calcul, en particulier des opérations logiques, le circuit mémoire comportant :
- une pluralité de cellules mémoires agencées en lignes et en colonnes le circuit mémoire étant doté :
- d'un étage de commande configuré pour activer une pluralité de cellules d'une même colonne donnée de cellules mémoires,
- d'au moins un étage de lecture pour détecter, consécutivement à ladite activation et à partir d'une ligne d'alimentation basse de ladite colonne donnée, un signal représentatif, en particulier un courant représentatif ou une tension représentative du résultat d'une opération logique ayant pour opérandes des données stockées dans des nœuds de stockage de ladite pluralité de cellules ou pour opérandes des données stockées des nœuds de stockage complémentaires de ladite pluralité de cellules. Les cellules peuvent être effet des cellules mémoires dotées de 2 nœuds de stockage amenés à stocker une information logique et une information logique complémentaire.

Pour détecter ou obtenir le résultat une opération logique, on lit donc ici un signal issu d'une ligne d'alimentation, en particulier la ligne d'alimentation basse plutôt qu'un signal issu de lignes de bits ou de lignes de sélection de colonne. Le fait de lire le signal sur une ligne d'alimentation plutôt que sur une ligne de bit ou une ligne de sélection de colonne permet d'améliorer la consommation ou tout au moins de pouvoir faire fonctionner le circuit mémoire à plus basse tension, par exemple à une tension qui peut être inférieure à 1.5 volts.

Un mode de réalisation prévoit un circuit mémoire adapté à mettre en œuvre des opérations de calcul, en particulier des opérations logiques, le circuit mémoire comportant :
- une pluralité de cellules mémoires agencées selon des lignes et des colonnes de cellules, chaque cellule mémoire étant dotée :
- d'un premier inverseur et d'un deuxième inverseur connectés de façon croisée entre un premier nœud de stockage de donnée et un deuxième nœud de stockage de donnée complémentaire, le premier inverseur et le deuxième inverseur étant connectés entre une ligne d'alimentation haute et une ligne d'alimentation basse partagées par des cellules d'une même colonne de cellules et,
- d'un premier transistor d'accès au premier nœud de stockage contrôlé par un premier signal de commande véhiculé par une première ligne de mot,
- d'un deuxième transistor d'accès au deuxième nœud de stockage contrôlé par un deuxième signal de commande véhiculé par une deuxième ligne de mot,
le circuit mémoire comprenant en outre :
- un étage de commande configuré pour activer au moins les premiers transistors d'accès ou au moins les deuxièmes transistors d'accès d'une pluralité de cellules d'une même colonne donnée de cellules mémoires,
- un étage de lecture pour détecter, consécutivement à ladite activation et à partir de la ligne d'alimentation basse de ladite colonne donnée, un signal représentatif du résultat d'une opération logique ayant pour opérandes des données stockées dans ladite pluralité de cellules.

En variante, on peut prévoir de lire un signal issu de la ligne d'alimentation haute. Dans ce cas l'étage de lecture est connecté à la ligne d'alimentation haute et configuré pour détecter consécutivement à ladite activation et à partir de la ligne d'alimentation haute, un signal représentatif du résultat d'une opération logique ayant pour opérandes des données stockées dans ladite pluralité de cellules. Dans ce mode de réalisation, là encore, le résultat d'une opération logique entre des cellules n'est pas détectée sur les lignes de bits, mais sur une ligne d'alimentation, qui est distincte des lignes de bits, ce qui laisse plus de flexibilité sur le niveau d'alimentation utilisé et permet de fonctionner en basse tension.

Un tel circuit est typiquement mis en œuvre avec des cellules élémentaires à 6 transistors, ce qui lui permet d'avoir un encombrement nettement réduit en particulier par rapport à un circuit mémoire doté de cellules 10T.

Par rapport notamment à un circuit mémoire doté de cellules 10T, un tel circuit mémoire peut permettre également d'avoir un nombre de lignes de mots réduits par rangée horizontale ou ligne de cellules, ce qui permet notamment un gain de place, ainsi qu'une consommation réduite.

Un tel circuit mémoire permet avantageusement de s'adapter à de cellules mémoires SRAM standard ou ayant une structure très proche d'une cellule SRAM standard, en particulier d'une cellule 6T standard.

Un tel circuit mémoire permet également de s'adapter à d'autres modes de fonctionnement et en particulier à un fonctionnement pour réaliser des opérations de lecture CAM dans lesquels on effectue une comparaison entre au moins un mot de donnée d'entrée et un mot de données qui est stocké par des cellules dudit circuit mémoire.

Avantageusement, l'étage de lecture peut être doté d'une portion de circuit pour convertir un courant issu de la ligne d'alimentation basse en une tension.

Avantageusement, l'étage de lecture peut être doté d'au moins un comparateur, pour comparer un signal (courant ou tension) issu de la ligne d'alimentation basse de ladite colonne donnée et consécutif à ladite activation, avec un seuil dudit comparateur. En variante, l'étage de lecture peut être doté d'un amplificateur de détection dont la sortie dépend du niveau d'un signal (courant ou tension) issu de la ligne d'alimentation basse appliqué en entrée dudit amplificateur de détection par rapport à un seuil dudit amplificateur de détection.

Le niveau du seuil, appelé seuil de détection peut dépendre de, et être adapté en fonction de l'opération logique mise en œuvre.

Ce seuil de détection peut être également adapté en fonction d'un nombre K de cellules de ladite pluralité de cellules de ladite colonne utilisées lors de l'opération logique mise en œuvre.

Un mode de réalisation particulier prévoit d'utiliser un nombre de cellules K inférieur au nombre N total de cellules de ladite colonne pour effectuer une opération logique.

Selon une réalisation particulière pour laquelle le signal représentatif est un courant issu de ladite ligne d'alimentation basse :
- lorsque ledit courant est inférieur ou égal à une valeur minimale, ladite opération logique peut être d'un premier type, en particulier de type **ET,**
- et/ou lorsque ledit courant atteint une valeur maximale, ladite opération logique peut être d'un deuxième type, en particulier de type **NON OU,**
- et/ou lorsque ledit courant a une valeur comprise entre ladite valeur minimale et ladite valeur maximale et différente de ladite valeur minimale et de ladite valeur maximale, ladite opération logique ladite opération logique peut être d'un troisième type, en particulier de type **OU EXCLUSIF.**

On se réfère ici à des opérations logiques de base **AND, NOR, XOR,** mais il est également possible de la même manière de détecter ou d'établir une distinction entre une opération de type **NON ET,** une opération de type **OU** et une opération de type **NON OU EXCLUSIF.**

La détection par l'étage de lecture résulte typiquement d'une comparaison dudit courant (ou d'une tension résultant d'une conversion dudit courant) à un seuil d'un bloc de circuit appelé bloc de comparaison, en particulier un comparateur ou un amplificateur de détection appartenant audit étage de lecture.

Ce seuil peut dépendre de, et être réglé en fonction de l'opération logique mise en œuvre.

Ce seuil peut être également modulé en fonction du nombre K de cellules activées pour effectuer une opération logique.

Selon un mode de réalisation particulier du circuit mémoire pour lequel le signal dans lequel le signal représentatif est détecté à partir d'un courant I_{LVS} issu de la ligne d'alimentation basse, et dans lequel :
- lorsque ledit courant I_{LVS} est comparé à une valeur dite « minimale », ladite opération logique est l'un de premier et deuxième types d'opérations ;
- et/ou lorsque ledit courant I_{LVS} est comparé à une valeur dite « maximale », ladite opération logique est l'autre des premier et deuxième types d'opérations ;
le premier type d'opération correspondant à une opération **ET** ou **NON ET,** et le deuxième type d'opération correspondant à une opération **NON OU** ou **OU** ;
- et/ou lorsque ledit courant I_{LVS} a une valeur comprise entre ladite valeur minimale et ladite valeur maximale tout en étant différente de ladite valeur minimale et de ladite valeur maximale, ladite opération logique est d'un troisième type, en particulier de type **OU EXCLUSIF** ou de type **NON OU EXCLUSIF,** la détection par l'étage de lecture résultant d'au moins une comparaison entre d'une part ledit courant I_{LVS} ou une tension résultant d'une conversion dudit courant I_{LVS} et d'autre part au moins un seuil de comparaison en courant ou en tension d'un bloc de comparaison dudit étage de lecture.

La détection dudit signal représentatif comprend une comparaison d'une tension provenant de la ligne d'alimentation basse à une tension de référence prédéterminée.

On peut alors, selon un mode de réalisation particulier, détecter, lorsque les premiers transistors d'accès sont activés, un état indiquant que les premiers nœuds reliés aux premiers transistors d'accès activés sont tous au niveau logique '1' ou sont tous au niveau logique '0', ou
de sorte à détecter, lorsque les deuxièmes transistors d'accès sont activés, un état indiquant que les deuxièmes nœuds reliés aux deuxièmes transistors d'accès activés sont tous au niveau logique '1' ou sont tous au niveau logique '0'.

La tension de référence prédéterminée peut être produite par un bloc de circuit programmable ou par une colonne factice de cellules.

Avantageusement, le circuit mémoire peut être pourvu d'au moins une colonne factice (dummy) de cellules mémoires factices connectées à une ligne d'alimentation basse factice, ledit étage de lecture comprenant en outre au moins un comparateur pour comparer ledit signal représentatif issu de ladite ligne d'alimentation basse de ladite colonne donnée à un signal de référence issu de la ligne d'alimentation basse factice connectée à ladite colonne factice.

Dans ce cas, lorsque ladite pluralité de cellules compte K (avec K ≥ 2) cellules, l'étage de commande est configuré en outre pour, lors de ladite activation des transistors d'accès desdites K cellules, activer concomitamment K cellules de ladite colonne factice.

L'étage de lecture peut être également doté d'un bloc d'identification permettant d'identifier une opération logique effectuée, ledit bloc d'identification étant configuré pour générer au moins un signal indicateur d'un type d'opération logique parmi une pluralité d'opérations logique prédéterminées, en particulier parmi une opération logique **OU EXCLUSIF** (ou sa complémentaire **NON OU EXLUSIF**), une opération logique **NON ET** (ou sa complémentaire **ET**), une opération logique **NON OU** (ou sa complémentaire **OU**).

Avantageusement, l'étage de lecture est doté d'au moins un amplificateur de détection, qui peut être de type à une entrée ou bien de type différentiel.

Selon une possibilité de mise en œuvre du circuit mémoire pour laquelle ledit signal représentatif est un courant issu de ladite ligne d'alimentation basse, l'étage de lecture peut comprendre en outre : une portion de circuit configurée pour convertir ledit courant en une tension de lecture, ladite tension de lecture étant transmise à un amplificateur de détection, cet amplificateur de détection étant de type à une entrée ou bien étant un amplificateur de détection de type différentiel amené à comparer la tension de lecture à une tension de référence.

Dans le deuxième cas, la tension de référence peut être avantageusement produite par une colonne factice formée de cellules factices, ladite tension de référence étant produite consécutivement à l'activation d'une cellule de ladite colonne factice concomitamment à ladite activation par ledit étage de commande des premiers transistors d'accès ou des deuxièmes transistors d'accès.

Selon une possibilité de mise en œuvre, l'étage de commande est configuré pour, selon une première phase, activer les premiers transistors d'accès de ladite pluralité de cellules puis selon une deuxième phase, activer lesdits deuxièmes transistors d'accès de ladite pluralité de cellules, l'étage de lecture étant configuré pour, lors de la première phase, détecter un courant issu de la ligne d'alimentation basse et provenant des premiers nœuds respectifs de ladite pluralité de cellules et pour, lors de ladite deuxième phase, détecter un courant issu de la ligne d'alimentation basse et provenant des deuxièmes nœuds respectifs de ladite pluralité de cellules.

Une telle activation en deux phases est obtenue typiquement par une commande en deux phases de premières lignes de mots reliées à ladite pluralité de cellules puis de deuxièmes lignes de mots reliées à ladite pluralité de cellules ou de deuxièmes lignes de mots puis de premières lignes de mots. Cette activation ou commande en deux phases permet d'établir une détection précise de l'opération logique réalisée et/ou du résultat de cette opération.

Avec une telle détection en deux phases, on vise notamment à détecter, si tous les premiers nœuds sont dans un même premier état logique '1' ou '0', puis, dans le cas contraire, si tous les deuxièmes nœuds sont dans un même état logique '0' ou '1', complémentaire du premier état. Une telle détection en deux phases s'applique tout particulièrement à une détection ou identification de plus de deux opérations logiques différentes.

Du fait que l'état du premiers nœud de stockage est complémentaire de celui du deuxième nœud, une activation des deuxièmes lignes de mots WL2 et la détection, à partir de cette activation, d'un cas par exemple où tous les deuxièmes nœuds F des cellules activées sont à '0', est équivalente à une détection que les premiers nœuds T des cellules activées sont à '1', cette détection pouvant faire suite à une activation des premières lignes de mots WL1.

Selon une possibilité de mise en œuvre du circuit mémoire, l'étage de commande peut être configuré pour, selon une première phase de fonctionnement, activer lesdits premiers transistors d'accès aux premiers nœuds respectifs de ladite pluralité de cellules, l'étage de lecture étant alors configuré pour, lors de la première phase, lorsqu'un signal issu de la ligne d'alimentation basse indique que les premiers nœuds sont tous à un même niveau logique donné, par exemple un niveau logique '1' : produire un premier signal indicateur d'un premier type d'opération logique, en particulier d'opération logique de type **ET (ou NON ET).**

L'étage de commande peut être également configuré pour, selon une deuxième phase consécutive à ladite première phase, activer lesdits deuxièmes transistors d'accès aux deuxièmes nœuds respectifs de ladite pluralité de cellules, l'étage de lecture étant configuré pour, lors de la deuxième phase, lorsqu'un signal issu de la ligne d'alimentation basse indique que les deuxièmes nœuds sont tous à un niveau logique donné, par exemple un niveau logique '1': produire un deuxième signal indicateur d'un deuxième type d'opération logique, en particulier de type **NON OU** (ou **OU**).

L'étage de lecture peut être configuré en outre pour, lorsque ni le premier signal ni le deuxième signal n'a été produit à l'issue de la deuxième phase, produire un troisième signal indicateur d'un troisième type d'opération logique, en particulier de type **OU EXCLUSIF** (ou **NON OU EXCLUSIF**).

Avantageusement, l'étage de lecture peut être doté d'un bloc d'identification, le bloc d'identification comprenant un premier bloc verrou apte, à partir d'un signal d'entrée dudit bloc d'identification, à produire et maintenir en sortie le premier signal indicateur d'un premier type d'opération logique et un deuxième bloc verrou apte, à partir du signal d'entrée dudit bloc d'identification, à produire et maintenir en sortie le deuxième signal indicateur d'un deuxième type d'opération logique, l'étage de commande étant configuré pour préalablement à la première phase,
- appliquer un signal de réinitialisation au premier bloc et au deuxième bloc verrou, puis,
- appliquer un premier signal d'activation au premier bloc verrou concomitamment à l'activation de premiers transistors d'accès,
- appliquer un deuxième signal d'activation au deuxième bloc verrou concomitamment à l'activation de deuxièmes transistors d'accès.

Selon une possibilité de mise en œuvre, l'étage de lecture peut être doté d'un multiplexeur à recevoir un premier signal indicateur d'un premier type d'opération logique, un deuxième signal indicateur d'un deuxième type d'opération logique, un troisième signal indicateur d'un troisième type d'opération logique, et pour transmettre en fonction d'une instruction relative à une sélection d'opération logique parmi lesdites premier type, deuxième type et troisième type d'opérations logiques, l'un desdits premier signal indicateur ou deuxième signal indicateur ou troisième signal indicateur.

Avantageusement, l'étage de lecture peut être doté de plusieurs comparateurs afin de mettre en œuvre une comparaison d'un signal représentatif d'un courant issu de la ligne d'alimentation basse (ou de la ligne d'alimentation haute) avec plusieurs seuils.

Selon un mode de réalisation particulier du circuit mémoire, l'étage de commande peut être configuré pour, lors d'une même phase donnée, activer les premiers transistors d'accès de ladite pluralité de cellules sans activer lesdits deuxièmes transistors d'accès aux deuxièmes nœuds respectifs de ladite pluralité de cellules ou activer lesdits deuxièmes transistors d'accès de ladite pluralité de cellules sans activer lesdits premiers transistors d'accès, la détection par l'étage de lecture résultant, lors de ladite phase donnée d'une première comparaison entre un signal représentatif dudit courant issu de la deuxième ligne d'alimentation et au moins un premier seuil d'un premier comparateur et lors de ladite même phase donnée d'une deuxième comparaison entre un signal représentatif dudit courant issu de la deuxième ligne d'alimentation et au moins un deuxième seuil d'un deuxième comparateur.

Une telle variante permet d'avoir accès aux résultats d'opérations logiques de trois types différents par exemple AND, NOR et XOR, ou NAND, OR et XNOR en un seul cycle de lecture, sans devoir nécessairement activer séquentiellement les premières lignes mot et deuxièmes lignes de mot.

Ainsi, selon un autre aspect, on prévoit un dispositif de mémoire adressable par contenu comprenant un circuit mémoire tel que défini plus haut.

### BRÈVE DESCRIPTION DES DESSINS

La présente invention sera mieux comprise à la lecture de la description d'exemples de réalisation donnés, à titre purement indicatif et nullement limitatif, en faisant référence aux dessins annexés sur lesquels:
- les figures 1A-1B servent à illustrer un circuit mémoire tel que mis en œuvre suivant un mode de réalisation de la présente invention, adapté à la mise en œuvre d'opérations de calcul et en particulier d'opérations logiques ;
- la figure 2 sert à illustrer un exemple de réalisation particulier dans lequel le circuit mémoire est doté d'une matrice de cellules et d'au moins une colonne factice (« dummy ») servant de référence afin d'établir une comparaison avec un signal issu d'une colonne de la matrice ;
- les figures 3, 4, 5 servent à illustrer différents exemples de réalisation particuliers d'un étage de lecture configuré pour lire un signal généré en pied d'une colonne d'alimentation de la matrice lorsqu'on effectue une opération logique entre des cellules de cette colonne ;
- la figure 6 sert à illustrer un exemple de réalisation de module permettant de générer des signaux de type drapeaux (flags) indicateurs d'une opération logique effectuée sur des cellules de la matrice ;
- la figure 7 sert à illustrer un exemple de multiplexeur qui, en fonction d'une instruction relative à une opération logique donnée parmi une pluralité d'opérations logiques prédéterminées permet de transmettre en sortie un signal de type drapeau indicateur du type d'opération logique donnée et le résultat de cette opération logique ;
- la figure 8 sert à illustrer un exemple particulier d'un étage ou bloc permettant de générer un signal drapeau indicateur d'une opération logique de type ET ;
- la figure 9 sert à illustrer un exemple particulier d'un étage ou bloc permettant de générer un signal drapeau indicateur d'une opération logique de type NON OU ;
- la figure 10 sert à illustrer un exemple de réalisation particulier d'un étage de lecture particulier adapté à la mise en œuvre d'une comparaison entre un signal représentatif d'un courant issu de la ligne d'alimentation basse et plusieurs seuils, afin notamment de pouvoir lire le résultat d'opérations logiques de 3 types différents sur un seul cycle de lecture ;

En outre, dans la description ci-après, des termes qui dépendent de l'orientation du dispositif comme par exemple « verticale », « horizontale », s'appliquent en considérant que le dispositif est orienté de la façon illustrée dans les figures.

Des parties identiques, similaires ou équivalentes des différentes figures portent les mêmes références numériques de façon à faciliter le passage d'une figure à l'autre.

### EXPOSÉ DÉTAILLÉ DE MODES DE RÉALISATION PARTICULIERS

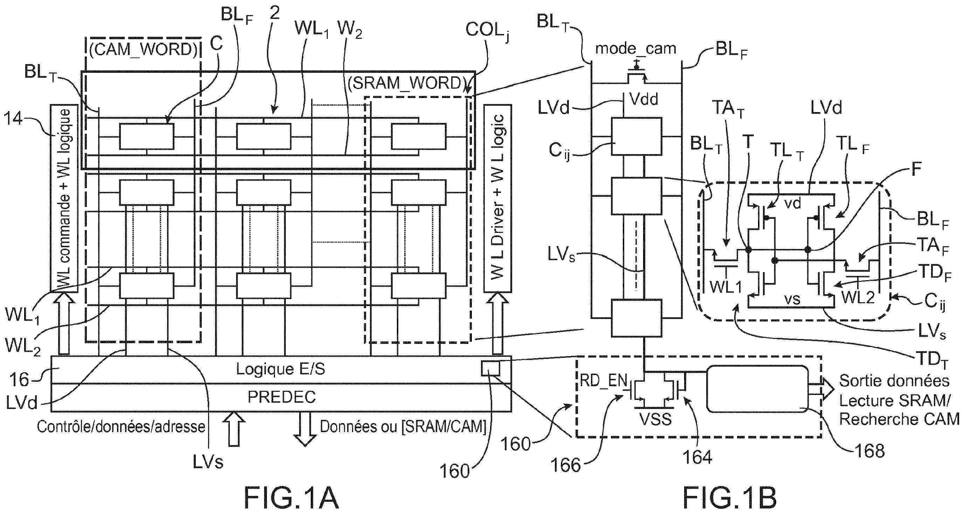

On se réfère à présent à la figure 1A, donnant un exemple de réalisation d'un circuit mémoire doté d'un ensemble de cellules mémoires C élémentaires et adapté non seulement à stocker des données mais également à effectuer *in situ* des opérations, en particulier des opérations logiques à partir de données stockées dans les cellules mémoires C élémentaires.

Les résultats de ces opérations peuvent être transmis à des circuits externes au circuit mémoire ou bien enregistrés dans ce circuit mémoire.

L'ensemble de cellules mémoires C élémentaires est agencé selon une matrice 2 comportant une pluralité de colonnes (dans l'exemple illustré des rangées verticales) de cellules et de lignes (dans l'exemple illustré des rangées horizontales) de cellules.

Dans cet exemple de réalisation, le circuit mémoire peut être également utilisé comme une mémoire à accès aléatoire RAM, en particulier SRAM, dans laquelle on vient notamment lire ou écrire des mots de données SRAM_WORD formés par, ou compris dans des lignes (ici des rangées horizontales) de cellules mémoires élémentaires de la matrice.

Le circuit mémoire peut être également utilisé comme une mémoire adressable par contenu (CAM). Chaque colonne de cellules forme par exemple un mot de mémoire CAM. Une telle mémoire CAM est notamment capable de comparer un mot de données d'entrée à un mot de données CAM_WORD mémorisé dans une colonne de cellules mémoires élémentaires. Typiquement, une information d'échec est susceptible d'être renvoyée par le circuit mémoire à chaque fois qu'un mot CAM_WORD dans la mémoire ne concorde pas avec le mot de données d'entrée, et une information de succès à chaque fois qu'un mot CAM_WORD dans la mémoire concorde avec le mot de données d'entrée. L'opération CAM et en particulier la détection de succès ou d'échec CAM peut être réalisée par exemple comme dans le document US9679649B2 émanant de la demanderesse.

Les cellules d'une même colonne ont typiquement une paire de lignes de bits BL_{T}, BL_{F} commune. Dans cet exemple, les cellules d'une même colonne sont également connectées à une ligne d'alimentation LVd dite « haute », pour polariser les transistors, cette ligne d'alimentation haute LVd étant apte à être mise à un potentiel d'alimentation, par exemple VDD. Les cellules d'une même colonne sont également connectées à une ligne d'alimentation LVs dite « basse » également appelée ligne de masse, susceptible d'être mise à un potentiel inférieur au potentiel d'alimentation et en particulier à un potentiel de référence VSS ou de masse GND. Le terme "connecté" est utilisé dans toute la description pour désigner une connexion qui peut-être directe ou qui peut se faire par l'intermédiaire d'un ou plusieurs autres composants comme des résistances, des condensateurs ou des transistors.

Le circuit mémoire a ici comme particularité d'avoir des cellules d'une même ligne de cellules ayant en commun deux lignes de mot WL1 et WL2 distinctes et qui peuvent être commandées indépendamment l'une de l'autre et sont aptes à recevoir des signaux de commande distincts en provenance du circuit de pilotage 14. Une connexion simultanée d'une cellule aux lignes de bits BLT, BLF ou séquentielle de cette même cellule à une ligne de bit puis à l'autre peut être ainsi réalisée. Une telle commande des paires de lignes de mot WL1, WL2 de chaque ligne de la matrice est réalisée à l'aide d'un étage de commande doté d'un circuit de pilotage 14 (WL DRIVERS + WL LOGIC) muni d'éléments de circuits logique.

Pendant une opération CAM, le circuit de pilotage 14 sélectionne typiquement toutes les lignes de mot WL1 ou bien toutes les lignes de mot WL2 afin d'activer toutes les cellules composant une colonne donnée de la matrice.

Dans un mode de fonctionnement particulier appelé IMC (pour « In Memory Computing »), afin de mettre en œuvre des opérations de calcul, et en particulier des opérations logiques, notamment des opérations logiques de type NON OU (NOR) ou de type OU EXCLUSIF (XOR), ou de type ET (AND), le circuit de pilotage 14 est adapté pour activer simultanément en lecture, via leurs lignes de mots WL1 ou WL2, un nombre donné K, avec K ≥ 2, de cellules élémentaires d'une même colonne du circuit, afin d'effectuer une opération logique entre ces K cellules. Le circuit de pilotage 14 active un nombre donné K ≤ N avec N le nombre de cellules d'une colonne, certaines cellules de la colonne pouvant rester alors inactivées autrement dit ne faisant pas l'objet d'un accès en lecture. Activer deux rangées de cellules peut être suffisant pour réaliser une opération logique, mais selon une particularité du présent circuit mémoire, on peut activer plus de deux rangées de cellules et donc plus de deux cellules par colonne et réaliser ainsi une opération logique à partir de plus de deux opérandes. Dans le mode de fonctionnement IMC du présent circuit mémoire on peut également activer plusieurs rangées de cellules sans nécessairement activer une colonne entière de cellules.

L'activation ou lecture des K cellules lors d'une opération logique peut se faire par sélection uniquement de leurs premières lignes de mot WL1 respectives ou bien par sélection uniquement de leurs deuxièmes lignes de mot WL2 respectives ou bien par sélection séquentielle uniquement de leurs lignes de mot WL1, puis uniquement de leurs lignes de mots WL2 ou bien uniquement de leurs lignes de mot WL2, puis uniquement de leurs lignes de mots WL1.

Le résultat de l'opération logique peut être lu ou la détection d'une opération logique peut être réalisée par le biais d'un étage de lecture 160 appartenant à un circuit d'entrée/sortie 16 (IO LOGIC), l'étage de lecture 160 étant connecté à une ligne d'alimentation de la colonne, dans cet exemple à la ligne d'alimentation basse LVs de la colonne auxquelles les K cellules appartiennent.

Le signal détecté est par exemple sous forme d'un courant issu de la ligne d'alimentation basse LVs à laquelle les K cellules sont reliées et qui peut être typiquement converti en une tension d'entrée en vue d'être utilisé par exemple par un amplificateur de lecture (« Sense Amplifier » selon la terminologie anglo-saxonne). Ainsi, la lecture du résultat d'une opération logique se fait ici par le biais de la ou les lignes d'alimentation, les lignes d'alimentation basses LVs dans cet exemple, plutôt que par lecture d'un signal émanant des lignes de bits.

Sur la figure 1B, un exemple de portion d'un tel étage de lecture 160 situé au pied d'une colonne COLj de cellules élémentaires est représenté.

L'étage de lecture 160 est ici connecté à la ligne d'alimentation basse LVs partagée ici par chaque cellule mémoire de la colonne COLj.

Selon un exemple, l'étage de lecture 160 peut être connecté à la ligne d'alimentation basse LVs au niveau du pied de la colonne COLj, et à la tension d'alimentation basse VSS par l'intermédiaire d'un transistor 164 monté en diode, de sorte que la tension sur la ligne d'alimentation basse LVs peut être autorisée à augmenter au-dessus de VSS pendant une opération de lecture. Par exemple, le transistor 164 est un transistor NMOS ayant sa grille connectée à son drain. Dans cet exemple, la ligne d'alimentation basse LVs est aussi par exemple connectée à la tension d'alimentation VSS par l'intermédiaire d'un transistor 166, qui est par exemple un transistor NMOS contrôlé par un signal d'autorisation de lecture RD_EN. Ainsi, la ligne d'alimentation basse LVS est placée à la tension d'alimentation VSS pendant des opérations de lecture.

L'étage de lecture 160 est ici muni de l'amplificateur de détection 168 (en anglais, « sense amplifier ») que l'on peut prévoir de partager par plusieurs voire l'ensemble des n colonnes de la matrice, ce qui peut être réalisé en prévoyant un multiplexeur intermédiaire (configuration n-MUX).

En variante, on peut prévoir d'associer un amplificateur de détection par colonne et de doter ainsi l'étage de lecture de plusieurs amplificateurs de détection 168 (configuration MUX1). Cette variante est particulièrement adaptée à un circuit mémoire dans lequel on souhaite effectuer des opérations de type CAM. L'étage de lecture 160 permet dans cet exemple, par le biais des transistors 166 et 164, de convertir le courant en une tension qui peut être détectée par un bloc amplificateur de détection 168 qui maintient la ligne d'alimentation basse LVs à un potentiel de référence par exemple GND lorsque la mémoire n'est pas lue et permet, lors d'une lecture, de limiter le nœud connecté à ligne d'alimentation basse LVs à un potentiel donné de sorte à conserver et ne pas perturber les données stockées dans les cellules sur lesquelles on réalise un accès en lecture.

D'autres structures permettant de convertir le courant pris en pied de la ligne d'alimentation basse LVs en une tension peuvent être envisagées par l'Homme du Métier.

La figure 1B donne également un exemple de schéma électrique équivalent d'une cellule mémoire élémentaire Cᵢⱼ de la colonne donnée COLj de cellules.

Cette cellule mémoire élémentaire Cᵢⱼ, a une structure semblable à celle d'une mémoire SRAM, dotée ainsi de deux nœuds de stockage T et F, prévus pour conserver une première information logique, et une deuxième information logique complémentaire de la première information.

Le maintien des informations logiques dans les nœuds T, F est assuré par des transistors TL_{T}, TL_{F}, TD_{T}, TD_{F} formant des inverseurs bouclés sur eux-mêmes, c'est à dire montés en antiparallèle ou tête-bêche. Ainsi, un inverseur INV1 est doté d'une entrée connectée au nœud de stockage T et à une sortie d'un autre inverseur, l'inverseur INV1 ayant en outre une sortie connectée au nœud stockage F et à une entrée de l'autre inverseur INV2. Cet autre inverseur INV2 est donc doté d'une entrée connectée au nœud de stockage F et d'une sortie connectée au nœud stockage T.

Dans l'exemple de réalisation illustré, la cellule élémentaire Cᵢⱼ a une structure de type communément appelée « 6T » et comporte ainsi 6 transistors, les deux inverseurs étant alors réalisés par, deux transistors de charge TL_{T}, TL_{F} dans cet exemple de type PMOS, et également appelés « pull up », et deux transistors de conduction TD_{T}, TD_{F}, dans cet exemple de type NMOS et également appelés « pull down ». La cellule Cᵢⱼ est également dotée de deux transistors d'accès TA_{T} et TA_{F}. Les transistors d'accès TA_{T} et TA_{F} sont connectés respectivement à une ligne de bit BL_{T} et à une ligne de BL_{F}, ces lignes de bits étant généralement partagées par les cellules SRAM de la colonne donnée COLⱼ.

Comme suggéré précédemment, l'accès aux nœuds de stockage T et F est commandé par des lignes de mot WL1, WL2 distinctes partagées par des cellules d'une même ligne de cellules à laquelle appartient la cellule élémentaire Cᵢⱼ. Le transistor d'accès TA_{T}, contrôlé par un signal de commande appliqué sur une ligne de mot WL1 est prévu pour permettre l'accès ou bloquer l'accès au nœud T. L'autre transistor d'accès TA_{F}, contrôlé par un signal de commande appliqué sur une autre ligne de mot WL2 est prévu pour permettre l'accès ou bloquer l'accès au deuxième nœud F. Lorsque les transistors TA_{T} sont commandés de sorte à permettre respectivement l'accès au nœud T et au nœud F, on dit qu'ils sont activés.

Dans l'exemple de cellule Cᵢⱼ illustré sur la figure 1B, le premier inverseur et le deuxième inverseur, et en particulier les transistors de charge TL_{T}, TL_{F}, sont connectés à une même ligne d'alimentation LVd haute, par exemple mise à un potentiel VDD.

Le premier inverseur et le deuxième inverseur, et en particulier les transistors de conduction TD_{T}, TD_{F}, sont également connectés à une même ligne d'alimentation basse LVs, cette ligne d'alimentation basse LVs étant à un potentiel inférieur à celui de la ligne d'alimentation haute, par exemple au potentiel de référence Vss ou potentiel de masse GND.

Les opérations de calcul et en particulier les opérations logiques susceptibles d'être mises en œuvre au sein du circuit mémoire sont effectuées entre des cellules d'une même colonne de cellules et plus particulièrement entre des nœuds de stockage de même type T ou F.

Ainsi, pour mettre en œuvre des opérations logiques, notamment des opérations logiques d'un premier type, en particulier OU (OR) ou « NON OU » (NOR), ou d'un deuxième type, en particulier ET (AND) ou « NON ET » (NAND), ou d'un troisième type, en particulier OU EXCLUSIF (XOR) ou « NON OU EXCLUSIF » (XNOR) sur une colonne de cellules de la matrice, par exemple sur la colonne donnée COLj, l'étage de commande doté du circuit de pilotage 14 des lignes de mots évoqué précédemment, peut être configuré pour activer au moins les premiers transistors d'accès TA_{T} d'au moins deux cellules de la colonne donnée COLj et pour détecter à partir de la ligne d'alimentation basse LVs de ladite colonne donnée COLj un signal représentatif du résultat d'une opération logique ayant pour opérandes des données stockées dans les nœuds T d'au moins deux cellules. Ce signal représentatif est typiquement obtenu à partir d'un courant issu de ladite ligne d'alimentation basse LVS.

On peut également réaliser une opération logique ayant pour opérandes les états des nœuds de stockage complémentaires F respectifs de plusieurs cellules, le circuit de pilotage 14 des lignes de mots étant alors configuré pour activer au moins les transistors d'accès TA_{F} respectifs de plusieurs cellules de la colonne donnée COLj et pour détecter à partir de la ligne d'alimentation basse LVs de ladite colonne donnée COLj un signal représentatif du résultat d'une opération logique ayant pour opérandes des données stockées dans les nœuds F desdites plusieurs cellules.

Du fait que les états des nœuds de stockage T et F sont complémentaires, une activation des deuxièmes lignes de mots WL2 et la détection, à partir de cette activation, d'un cas par exemple où tous les nœuds F des cellules activées sont à '0', est équivalente à une détection que les nœuds T des cellules activées sont à '1', cette détection pouvant faire suite à une activation des premières lignes de mots WL1.

On considère par exemple un cas dans lequel on effectue une pré-charge des lignes de bits BL_{T}, BL_{F} à une tension d'alimentation qui peut être de Vdd, et dans lequel on effectue une opération logique à partir des niveaux respectifs stockés aux nœuds T respectifs de plusieurs cellules données d'une colonne COLj dont on commande les premières lignes de mots WL1 respectives. Les cellules sont dans cet exemple polarisées de sorte que lorsqu'une cellule stocke une valeur logique '0', un courant s'écoule à travers cette cellule sur la ligne d'alimentation basse LVs. Autrement dit, le transistor TL_{T} (représenté en figure 1B) est conducteur ce qui veut dire que la tension au nœud F est supérieure à celle présente sur le nœud T, la tension au nœud F étant égale à Vdd et celle sur le nœud T étant égale à la tension Vss. Par raccourci, l'homme du métier dira que le nœud F est au niveau « 1 » et le nœud T au niveau « 0 » ; la valeur codée par la cellule étant dans cet exemple prise égale à « 0 » dans ce cas de figure ; étant entendu que la valeur codée par la cellule serait «1 » si les tensions respectives des nœuds F et T étaient inverses. Ainsi, par raccourci, on peut dire que la valeur de la cellule correspond à la valeur de son nœud T.

On peut alors considérer plusieurs cas :
Selon un premier cas, le courant I_{LVS} détecté sur la ligne d'alimentation basse LVs reste inférieur ou égal à une valeur minimale, ce qui indique qu'aucune des cellules données ne stocke de niveau logique '0', autrement dit que tous les nœuds T sont au niveau '1'. Ce premier cas, avec une détection de ce courant de valeur minimale par le circuit de lecture 160, correspond par exemple à une opération logique ET (AND). Ainsi, le circuit de lecture sortira une valeur « 1 » si le courant est inférieur ou égal à cette valeur minimale et « 0 » dans le cas inverse. Cet état de la ligne d'alimentation basse LVs est susceptible de déclencher un signal drapeau identifiant un tel type d'opération logique. Selon une variante de réalisation, le circuit de lecture pourrait sortir une valeur « 0 » si le courant est inférieur ou égal à cette valeur minimale et « 1 » dans le cas inverse, et l'opération réalisée serait une opération NON ET (NAND).

Selon un deuxième cas, le courant I_{LVS} détecté sur la ligne d'alimentation basse LVs atteint une valeur maximale, ce qui indique que toutes les cellules données stockent un niveau logique '0'. Ce deuxième cas, avec une détection de ce courant de valeur maximale par le circuit de lecture 160, correspond par exemple à une opération logique NON OU (NOR).). Ainsi, le circuit de lecture sortira une valeur « 1 » si le courant est supérieur ou égal à cette valeur maximale et « 0 » dans le cas inverse. Cet état de la ligne d'alimentation basse LVs est susceptible de déclencher un signal drapeau identifiant un tel type d'opération logique. Selon une variante de réalisation, le circuit de lecture pourrait sortir une valeur « 0 » si le courant est supérieur ou égal à cette valeur maximale et « 1 » dans le cas inverse, et l'opération réalisée serait une opération OU (OR).

Selon un troisième cas, le courant I_{LVS} détecté sur la ligne d'alimentation basse LVs est tel que I_{LVS} est compris entre la valeur minimale et ladite valeur maximale tout en étant différent de ces valeurs, ce qui indique que certaines des cellules données stockent un niveau logique '0' tandis que d'autres cellules parmi les cellules données stockent un niveau logique '1'. Ainsi, après détection par le circuit de lecture que ce courant est compris entre les valeurs minimales et maximales et différent de ces dernières, cela correspond par exemple à une opération logique OU EXCLUSIF (« XOR »). Ainsi, le circuit de lecture sortira une valeur « 1 » si le courant est compris entre les valeurs minimale et maximale et « 0 » dans le cas inverse. Cet état de la ligne d'alimentation basse LVs est susceptible de déclencher un signal drapeau permettant d'identifier un tel type d'opération logique. Selon une variante de réalisation, le circuit de lecture pourrait sortir une valeur « 0 » si le courant est compris entre les valeurs minimale et maximale et « 1 » dans le cas inverse, et l'opération réalisée serait une opération NON OU EXCLUSIF (XNOR).

Le tableau ci-après sert à résumer les cas exposés précédemment.

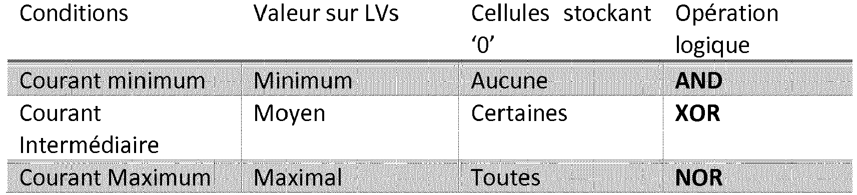

Dans l'exemple qui vient d'être donné on établit une distinction entre trois types d'opérations logiques de base AND, NOR, XOR. De la même manière, on peut également établir une distinction entre des opérations NAND/OR/XNOR, dans la mesure où ces opérations sont complémentaires des opérations AND, NOR, XOR, et que leur détection peut être obtenue soit simplement par une inversion du résultat d'une des opérations AND, NOR, XOR (en inversant également un signal drapeau correspondant), soit en utilisant un circuit de lecture structurellement prévu pour délivrer une opération inverse, comme décrit précédemment.

Il est également possible de réaliser une autre opération logique par activation de nœuds complémentaires de ceux ayant permis d'obtenir le résultat d'une des opérations AND, NOR par détection respectivement par exemple d'un courant minimal et d'un courant maximal. Par exemple, si une activation d'un ensemble de premières lignes de mots associées à un premier ensemble de premiers nœuds T, permet d'obtenir le résultat ou d'identifier une opération logique AND avec par exemple un circuit de lecture permettant de détecter un courant de valeur minimale, une activation correspondante d'un ensemble de deuxièmes lignes de mots associées à un deuxième ensemble de deuxièmes nœuds F complémentaires, permet d'obtenir le résultat ou d'identifier une opération logique NOR, avec le même circuit de lecture permettant de détecter un courant de valeur minimale. De façon similaire, si une activation d'un ensemble de premières lignes de mots associées à un premier ensemble de premiers nœuds T, permet d'obtenir le résultat ou d'identifier une opération logique NOR avec un circuit de lecture permettant de détecter un courant de valeur maximale, une activation correspondante d'un ensemble de deuxièmes lignes de mots associées à un deuxième ensemble de deuxièmes nœuds F complémentaires, permet d'obtenir le résultat ou d'identifier une opération logique AND, avec le même circuit de lecture permettant de détecter un courant de valeur maximale.

De même, dans l'exemple qui vient d'être décrit il est prévu par exemple qu'une opération logique AND soit identifiée, lorsque par le biais de la ligne d'alimentation basse LVs, on détecte que toutes les cellules stockent la valeur '1', toujours en considérant que la convention de valeur attribuée à une cellule est celle évoquée supra, que l'on réalise une détection de valeur minimale et que les premières lignes de mots WL1 sont activées. En variante, si l'on utilise une convention inverse de valeur attribuée à une cellule et que les deuxièmes lignes de mots WL2 sont activées, on peut prévoir qu'une opération logique AND soit identifiée, lorsque, par le biais de la ligne d'alimentation basse LVs, on réalise une détection de valeur minimale et que l'on détecte que toutes les cellules activées stockent la valeur '1'. Selon cette variante, une détection que toutes les cellules activées stockent la valeur '0', permet alors d'identifier une opération logique NOR.

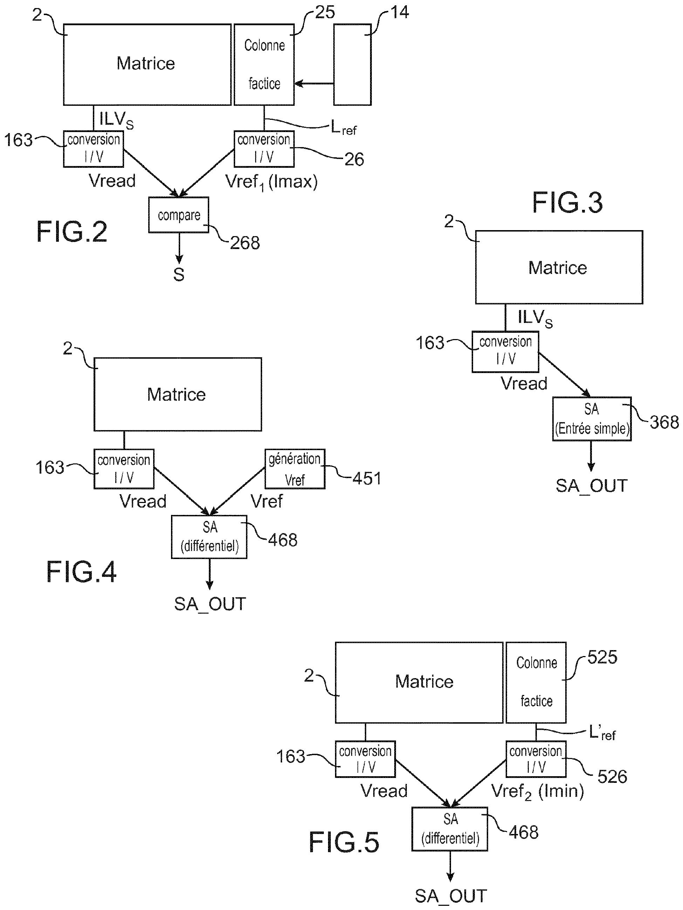

Pour permettre une détermination précise du résultat de l'opération logique et/ou du type d'opération logique réalisée, on peut prévoir, comme dans l'exemple de la figure 2, d'associer la matrice 2 de cellules élémentaires à une colonne 25 dite factice (en anglais « dummy ») composée de cellules mémoires factices (« dummy cells »), c'est-à-dire qui servent de référence ou de cellules témoins plutôt que de moyen de stockage de donnée. Les cellules factices de la colonne factice 25 permettent de produire des signaux électriques de référence et sont de préférence en nombre égal à celui d'une colonne de la matrice.

Typiquement, les cellules factices peuvent avoir une structure semblable à celles des cellules de la matrice 2 mémoire. Les cellules factices peuvent être dotées d'un nœud connecté à un potentiel donné par exemple d'alimentation VDD ou un potentiel de masse GND de manière à forcer la cellule à une valeur donnée, et obtenir ainsi une cellule sur laquelle on ne peut réaliser un accès en écriture mais à laquelle on peut accéder en lecture. Une cellule factice permet ainsi de lire une donnée de référence qui reste la même pour tous les accès en lecture.

Comme les cellules élémentaires de la matrice, les cellules factices de la colonne factice 25 sont reliées à une ligne d'alimentation basse factice ou ligne de référence factice Lref qui peut être reliée au même potentiel que la ligne d'alimentation basse LVS, en particulier à VSS ou GND et sur laquelle on prélève un courant qui dépend typiquement du nombre de cellules factices activées. Pour servir de référence et délivrer un courant de référence, les cellules factices de la colonne factice 25 peuvent être configurées de sorte à stocker un même niveau logique donné. Par exemple, on peut prévoir que toutes les cellules factices de la colonne factice 25 sont mises à un niveau logique '0' et que quelle que soit la ligne de mots WL1 ou WL2 activée la cellule factice soit conductrice. La colonne 25 de cellules factices est typiquement reliée au même nombre de ligne de mots WL1 et/ou WL2 qu'une colonne de cellules élémentaires de la matrice 2. Ainsi, avantageusement, lorsque l'étage de commande active des transistors d'accès TA_{T} et/ou TA_{F} de K cellules d'une colonne donnée de la matrice 2, il active concomitamment K cellules factices de ladite colonne factice 25. Cela permet d'obtenir un courant de référence dépendant du nombre de cellules activées.

Le signal de référence, par exemple sous forme d'une tension ou d'un courant de référence, issu(e) de la colonne factice consécutivement à l'activation de K cellules peut être prévu de manière à avoir un niveau différent de celui pris en pied de colonne et consécutif à l'activation du même nombre K de cellules dans une colonne de cellules servant d'opérandes. Ainsi, on peut effectuer une comparaison entre le signal de référence et le signal pris en pied de colonne à partir de leurs lignes d'alimentation basses LVs respectives pour réaliser l'opération logique souhaitée.

Cette différence peut être réglée au moment de la conception en fonction de la précision de détection requise. Elle est typiquement prévue suffisante pour permettre de différencier deux signaux ayant un même nombre de bits dans un même état, par exemple un état '1', à l'exception de 1 bit.

On considère par exemple le cas décrit précédemment avec une pré-charge à une tension d'alimentation Vdd, et des cellules factices polarisées de sorte que lorsqu'une cellule factice stocke une valeur logique '0', un courant s'écoule à travers cette cellule. Ainsi, les cellules factices activées délivrent un courant de référence maximal Imax sur la ligne Lref qui correspond au cas où toutes les cellules stockent un niveau logique '0'. Le courant Imax de référence est modulé en fonction du nombre d'opérandes de l'opération logique dans la mesure où le nombre de cellules factices activées dans la colonne 25 correspond au nombre de cellules réalisant l'opération logique dans une colonne donnée de la matrice 2.

Afin de pouvoir comparer le signal issu d'une colonne donnée COLj de la matrice 2 du fait d'une opération logique entre cellules de cette colonne donnée et celui délivré par la colonne 25 factice, on peut établir au préalable une conversion courant/tension et prévoir un étage 163 du circuit de lecture permettant de convertir le courant I_{LVS} en un potentiel Vread en sortie de la matrice 2. De même, on établit alors une conversion courant/tension avec un étage 26 permettant de convertir le courant Iₘₐₓ de référence en un potentiel de référence Vref1 en sortie de la colonne factice 25. Une comparaison du potentiel Vread et du potentiel Vref1, formant un seuil, est typiquement réalisée à l'aide d'un bloc 268 comparateur. On détecte l'état d'un signal S de sortie du comparateur 268 pour connaître le résultat d'une opération logique.

Pour que le comparateur 268 du circuit de lecture fonctionne correctement, en comparant les tensions générées par la matrice 2 et par la colonne factice, il faut que ces tensions résultant de courants Is et Iref respectivement sur la ligne d'alimentation basse LVs et la ligne d'alimentation basse factice Lref diffèrent de préférence d'une valeur intermédiaire par rapport à un cas correspondant à une différence d'un seul bit entre les niveaux logiques de la pluralité de cellules à laquelle on applique l'opération logique. Si pour n cellules sélectionnées stockant le niveau logique '0' dans la matrice, la tension de sortie VX est générée et si pour n-1 cellules stockant la valeur '0' la tension VY est produite et que VX>VY, la tension de référence Vref₁, servant de seuil pour la comparaison, remplit de préférence la condition VX>Vref₁>VY et les différences VX-Vref₁, Vref₁-VY sont préférentiellement supérieures à l'offset du comparateur 268. La différence entre la tension prise en pied d'une colonne activée et la tension de référence servant de seuil peut être réglée au moment de la conception du circuit mémoire au niveau de l'étage de conversion courant tension 163 et/ou au niveau de la colonne factice 25, et/ou de l'étage 26. On compare ainsi, un signal pris en pied de colonne d'une colonne activée à un seuil adaptable en fonction d'un nombre K de cellules activées dans cette colonne pour effectuer une opération logique.

Pour réaliser une opération logique avec plus de deux opérandes et pouvant requérir une activation d'un nombre supérieur à deux de rangées de cellules mémoires élémentaires autrement dit d'une activation d'un nombre supérieur à deux de lignes de mots, tout en conservant une fiabilité de détection du résultat de l'opération et/ou du type d'opération logique effectuée et ce même lorsque le nombre de lignes de mots ou de rangées de cellules activées est important, un mode de réalisation particulier prévoit un fonctionnement en deux phases et en particulier en deux cycles distincts de commande des lignes de mots WL1 puis WL2 ou WL2 puis WL1.

Pour ce mode de réalisation particulier, l'étage de commande, et en particulier son circuit de pilotage 14 des lignes de mots WL1, WL2 évoqué précédemment, est configuré pour, selon une première phase activer les premiers transistors d'accès TA_{T} d'une pluralité de cellules afin de détecter un courant sur une ligne d'alimentation basse LVs provenant des nœuds de stockage T de cette pluralité de cellules, puis, selon une deuxième phase, activer les deuxième transistors d'accès TA_{F} d'une pluralité de cellules afin de détecter un courant sur la ligne d'alimentation basse LVs provenant des nœuds de stockage complémentaires F respectifs de cette même pluralité de cellules.

Alternativement, l'activation en deux phases peut être telle que le circuit de pilotage 14 active, lors de la première phase, par le biais des deuxièmes lignes de mots WL2 les deuxièmes transistors d'accès TA_{F} de la pluralité de cellules, puis lors de la deuxième phase, active les premiers transistors d'accès TA_{T} de cette même pluralité de cellules.

On utilise en particulier une telle activation en deux phases afin d'identifier de manière fiable un type d'opération logique effectuée, en détectant par exemple un cas particulier dans lequel tous les nœuds de stockage des cellules servant d'opérandes sont à un même niveau logique, en particulier un niveau logique '1' conduisant à un niveau de courant minimal sur la ligne d'alimentation LVs.

La détection d'un cas où tous les nœuds d'un même type sont à un niveau logique '1' peut s'avérer particulièrement fiable. En effet, si l'on se place par exemple dans des conditions de pré-charge et de polarisation des cellules telle qu'évoquée précédemment, la différence de potentiels entre le potentiel établi à partir du signal détecté sur la ligne d'alimentation LVs basse et correspondant au cas où tous les nœuds activés sont à un niveau logique '1' et celui correspondant au cas où l'essentiel des nœuds activés sont à un niveau logique '1' sauf un seul nœud à un niveau logique '0' est maximale.

Une identification d'opération logique en deux phases, ΦI, Φ2 peut être menée selon les conditions résumées dans le tableau ci-dessous.

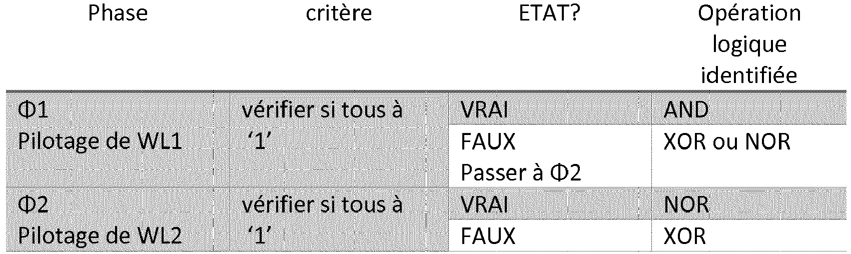

Dans cet exemple, l'activation en deux phases peut être la suivante :
lors de la première phase Φ1, le circuit de pilotage 14 commande les lignes de mots WL1 d'une pluralité de cellules, et l'on détecte le signal issu de la ligne d'alimentation LVs basse de la colonne à laquelle cette pluralité de cellules appartient pour vérifier si tous les nœuds T sont par exemple à un niveau logique '1'. On réalise alors dans cet exemple l'opération AND (en détectant si le courant est de valeur minimale).

Si c'est le cas, un signal drapeau (« flag » selon la terminologie anglo-saxonne) AND_flag indicateur d'opération logique ET (AND) est déclenché.

Dans un cas contraire, la deuxième phase Φ2 est déclenchée en pilotant (application d'un potentiel de commande) les lignes de mots WL2 de la pluralité de cellules, et l'on détecte le signal issu de la ligne d'alimentation LVs basse de la colonne à laquelle cette pluralité de cellules appartient pour vérifier si tous les nœuds F sont à un niveau logique '1'. On réalise alors dans cet exemple une opération NOR (en détectant si le courant est de valeur minimale).

Si c'est le cas, c'est que tous les nœuds T contenant une information logique complémentaire des nœuds F se trouvaient au niveau logique '0' un signal drapeau NOR_flag indicateur d'opération logique NON OU (NOR) est déclenché.

Dans le cas contraire, et si aucun des signaux drapeaux NOR_flag ou NAND_flag n'a été activé, un signal drapeau XOR_flag indicateur d'opération logique OU EXCLUSIF (XOR) est déclenché. On peut alors fournir le résultat de l'opération XOR, elle vaudra « 1 » si l'opération AND donne « 0 » et l'opération NOR donne « 0 », et inversement.

Le fonctionnement en deux phases décrit plus haut permet ainsi avantageusement de détecter une opération de type XOR ou sa complémentaire XNOR en deux cycles distincts consécutifs, en utilisant un même élément de comparaison recherchant un courant de valeur minimale.

On peut prévoir un déclenchement automatique d'une séquence dans laquelle on effectue la première phase puis la deuxième phase.

En variante, afin de réduire la consommation énergétique du circuit mémoire, on peut prévoir avantageusement, que l'étage de commande ne déclenche la deuxième phase Φ2 que lorsque le signal drapeau AND_flag indicateur d'opération logique ET n'a pas été activé à l'issu de la première phase.

Une détection du signal issu de la ligne d'alimentation basse LVs et vérification à partir de cette détection de la condition selon laquelle tous les premiers nœuds ou tous les deuxièmes nœuds sont à un niveau logique donné, en particulier un niveau logique '1' peut être mise en œuvre à l'aide d'un étage de lecture muni d'un amplificateur de détection (en anglais, « sense amplifier »).

Dans l'exemple de réalisation d'un circuit de lecture illustré sur la figure 3, un étage 163 permettant de convertir le courant I_{LVS} prélevé sur la ligne d'alimentation basse en un potentiel Vread, est relié à un amplificateur de détection 368.

Selon une exemple de réalisation particulier, correspondant à des conditions de précharge et de polarisation évoquées précédemment, si les nœuds stockage auxquels on accède sont tous à un niveau logique '1', la ligne d'alimentation basse LVs de la colonne de cellules sur laquelle on réalise l'opération reste à un potentiel de référence Vss ou GND tandis qu'un signal de sortie SA_OUT de l'amplificateur de détection 368 se trouve par exemple par conséquent à un niveau logique '1', indicateur que le critère est rempli, autrement dit que les nœuds stockage auxquels on accède sont tous à un niveau logique '1'.

Dans le cas où au moins un des nœuds de stockage auxquels on accède est à un niveau logique '0', un courant circule sur la ligne d'alimentation basse LVs de la colonne de cellules et modifie le signal Vread, ce qui maintient le signal de sortie SA_OUT de l'amplificateur de détection 368 au même niveau, par exemple à un niveau logique '0'.

Dans le cas où l'amplificateur de différence comporte plusieurs sorties on peut utiliser l'une ou l'autre des sorties pour détecter si le critère précité est rempli.

Dans l'exemple de réalisation illustré sur la figure 4, le circuit de lecture comporte un amplificateur de détection 468 de type différentiel pour comparer le signal Vread à un signal de référence Vref formant un seuil.

Le seuil ou signal de référence Vref peut être généré par un bloc 451 de circuit programmable, en particulier à résistances programmables, pour permettre de fournir à l'amplificateur de détection 468 différentiel une valeur de tension de référence qui peut éventuellement dépendre du nombre de lignes activées, et peut dépendre du niveau de précision requis par le concepteur.

Ce seuil ou signal de référence Vref est prévu de préférence entre une valeur de potentiel Vpred1 prédéterminée correspondant par exemple à un cas dans lequel tous les nœuds de stockage auxquels on accède sont à un niveau logique donné '1' et une autre valeur de potentiel Vpred2 prédéterminée correspondant par exemple à un cas dans lequel tous les nœuds de stockage auxquels on accède sont à un niveau logique donné '1' excepté un nœud de stockage. Un tel signal de référence Vref permet de réaliser une détection de la présence ou non d'un courant de valeur minimale.

Un autre exemple de réalisation illustré sur la figure 5, prévoit un amplificateur de détection 468 de type différentiel configuré pour comparer le signal Vread qu'il reçoit en entrée à un seuil sous forme d'un signal de référence Vref2 reçu à une autre entrée et généré cette fois par le biais d'une colonne factice 525 formée de cellules mémoires factices qui sont reliées à une ligne d'alimentation basse de référence L'ref. Dans cet exemple, le circuit de commande est configuré pour n'activer qu'une cellule factice afin de délivrer un courant de référence minimal Imin sur la ligne d'alimentation basse de référence L'_{ref}. Les cellules factices peuvent, comme indiqué précédemment, être sous forme de cellules 6T conventionnelles avec un nœud forcé à un potentiel donné par exemple de VDD et qui peut ainsi imposer à ces cellules un niveau logique donné pour toutes les opérations de lecture que l'on effectue sur elles.

De même, on établit alors une conversion courant/tension avec un étage 526 permettant de convertir le courant Iₘᵢₙ de référence en un potentiel de référence Vref2 en sortie de la colonne factice 525.

Afin que la comparaison réalisée par l'amplificateur 468 permette de différencier deux valeurs de Vread correspondant respectivement à un courant très faible (cas où aucune des cellules ne conduit du courant) et un courant un peu plus élevé (cas où une seule cellule conduit du courant), le potentiel de référence Vref2 généré est compris entre ces deux valeurs de Vread. Ainsi, soit l'étage de conversion 526 réalise une conversion différente de celle réalisée par l'étage de conversion donnant Vread, soit les étages de conversion courant-tension sont les mêmes et la cellule factice utilisée est adaptée de sorte à délivrer un courant inférieur au courant délivré par une cellule de la matrice.

Dans l'un ou l'autre des exemples de réalisation décrits précédemment, le signal de sortie SA_OUT de l'amplificateur de détection 368 ou 468 peut être ensuite traité afin d'identifier une opération logique donnée parmi une pluralité d'opérations logique déterminées, selon un processus de traitement qui peut être semblable à celui en deux phases décrit précédemment et résumé dans le précédent tableau.

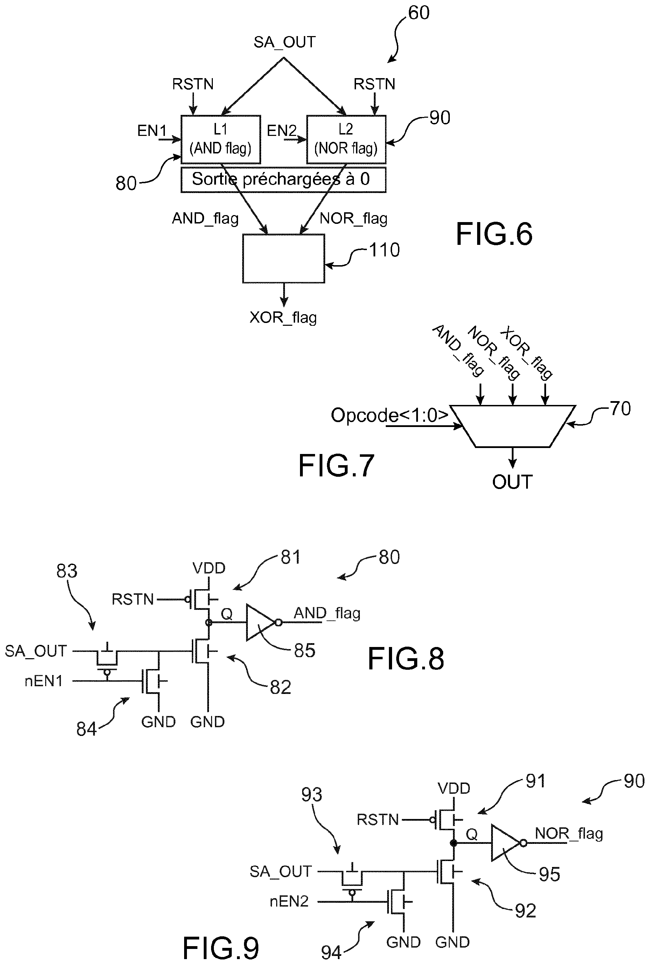

Sur la figure 6 un exemple d'étage 60 de traitement, recevant en entrée le signal SA_OUT généré par l'amplificateur de détection 368 ou 468 et apte à générer des signaux AND_flag, NOR_flag, XOR_flag de type drapeaux identificateurs d'opérations logiques est représenté de manière schématique.

Dans cet exemple, l'étage 60 de traitement comprend un premier bloc verrou 80, typiquement sous forme d'une bascule asynchrone (« latch » selon la terminologie anglo-saxonne), apte à produire et maintenir en sortie un signal drapeau AND_flag indicateur d'une opération logique de type « ET », ainsi qu'un deuxième bloc 90, qui peut être également d'une bascule asynchrone (latch) apte à produire et maintenir en sortie un signal drapeau NOR_flag indicateur d'une opération logique de type « NON OU ».

Les blocs 60, 80 permettent de verrouiller leur signal drapeau respectif et de le conserver jusqu'à ce que le processus de traitement en une ou deux phases et tel que décrit plus haut soit achevée. Les signaux drapeau AND_flag, NOR_flag correspondent ici à la sortie SA_OUT de l'amplificateur différentiel.

Le signal de réinitialisation RSTN en entrée des blocs verrou 80, 90 permet de réinitialiser les sorties respectives de ces blocs, par exemple à un niveau logique donné, dans cet exemple '0', avant que la séquence en deux phases Φ1, Φ2 ne démarre. Les blocs verrou 80, 90 sont dans cet exemple configurés pour stocker le signal SA_OUT de sortie consécutivement à la réception d'un signal d'activation EN1, EN2, et ce, jusqu'à réception d'un nouveau signal de réinitialisation RSTN. Les signaux d'activation EN1, EN2 permettent d'établir une synchronisation et transmettre cette sortie avec un délai suffisant pour permettre à l'amplificateur de s'établir à sa valeur correcte de sortie.

Lors de la première phase Φ1, autrement dit la phase durant laquelle des lignes de mots WL1 permettent d'activer les transistors TA_{T} d'accès aux nœuds T de certaines cellules servant à produire les opérandes d'une opération logique à identifier, le premier bloc verrou 80 reçoit un premier signal d'activation EN1. Une fois le premier signal d'activation EN1 reçu, la sortie sur premier bloc dépend du signal SA_OUT de l'amplificateur de détection.

Lors de la deuxième phase Φ2, autrement dit la phase durant laquelle des lignes de mots WL2 permettent d'activer les transistors TA_{F} d'accès aux nœuds F desdites certaines cellules, le deuxième bloc verrou 90 reçoit un deuxième signal d'activation EN2. Une fois le deuxième signal d'activation reçu, la sortie sur premier bloc dépend du signal SA_OUT de l'amplificateur de détection.

Le signal SA_OUT permet d'indiquer lorsque lesdites certaines cellules ne sont pas toutes au même niveau logique. Si c'est le cas, à la fois durant le premier cycle et durant le deuxième cycle, le premier bloc verrou 80 ne produit pas de signal drapeau AND_flag et le deuxième bloc verrou 90 ne produit pas de signal drapeau NOR_flag, ce qui déclenche une production d'un signal drapeau XOR_flag, par le biais d'une porte logique 110, par exemple de type NON OU (NOR) recevant en entrée les signaux de sortie respectifs des blocs verrou 80, 90.

Selon un possibilité de mise en œuvre, les blocs verrou 80, 90 permettant de générer les signaux de drapeaux AND_flag, NOR_flag peuvent être réalisés en variante à l'aide de bascules synchrones.

On considère par exemple un cas dans lequel les signaux de drapeau AND_flag, NOR_flag et XOR_flag sont actifs à l'état haut, autrement dit à un niveau logique '1'.

Le signal SA_OUT de sortie de l'amplificateur indique selon sa valeur si au moins un nœud parmi les nœuds servant d'opérandes est à un niveau logique différent de celui des autres nœuds, ou si tous les nœuds sont à la même valeur. Par exemple en passant à un niveau logique '0' le signal SA_OUT indique qu'au moins un nœud est à un niveau logique '1'. Les sorties des blocs verrou 80, 90 peuvent être alors également au niveau logique '0', indiquant par exemple que ni une opération logique ET, ni une opération logique NON OU n'a été détectée. Les sorties des blocs verrou 80, 90 passent d'un niveau '0' à un niveau '1' si une opération ET ou une opération NON OU a été détectée.

La porte logique 110 prévue en sortie peut dans ce cas être par exemple une porte de type OU (OR) qui, lorsque ses deux entrées sont au niveau logique '0', indique alors en sortie qu'une opération logique OU EXCLUSIF a été détectée et que le résultat de l'opération logique OU EXCLUSIF vaut « 1 ». Dans les autres cas, c'est-à-dire si au moins un des registres L1 et L2 stocke une valeur 1 alors le résultat de l'opération logique OU EXCLUSIF vaut « 0 ». On peut prévoir d'utiliser les signaux de drapeaux AND_flag, NOR_flag, XOR_flag, susceptibles d'être générés par l'étage de traitement 60 décrit précédemment afin de fournir un résultat de l'opération logique réalisée. Pour cela, on peut prévoircomme dans l'exemple de réalisation illustré sur la figure 7, un multiplexeur 70 avec 3 entrées AND_flag NOR_flag, XOR_flag. Ces entrées correspondent aux sorties respectivement du premier bloc 70, du deuxième bloc 90 et de la porte logique 110 décrits précédemment.

En fonction d'une instruction de type opcode ou code 'opération Opcode<1:0>', par exemple à 2 bits qui détermine un type d'opération logique que l'on souhaite réaliser, en particulier parmi 3 opérations logiques OU EXCLUSIF (XOR), NON OU (NOR), ET (AND), le multiplexeur 70 est configuré pour produire en sortie OUT un signal correspondant à l'une des trois entrées AND_flag NOR_flag, XOR_flag. Le signal OUT de sortie du multiplexeur 70 est ainsi susceptible de donner directement le résultat de l'opération logique. Le tableau ci-dessus répertorie différents cas de valeurs des signaux de type drapeau AND_flag NOR_flag, XOR_flag indicateurs respectivement d'opération logiques ET, NON OU, OU EXCLUSIF, en fonction des niveaux logiques stockés dans des nœuds de différentes cellules, dans cet exemple 4, réparties sur 4 lignes différentes de la matrice de cellules.

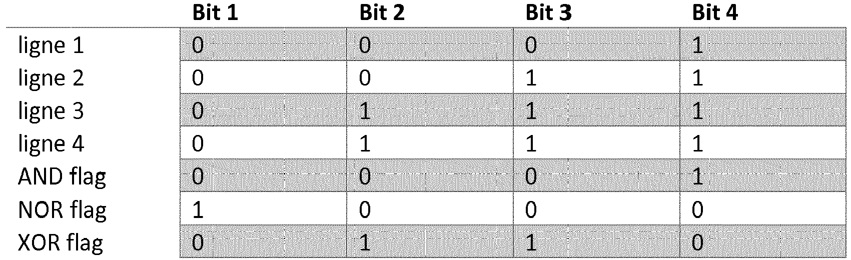

Dans la mesure où un circuit mémoire peut comprendre plusieurs étages de lecture tel que décrit précédemment, on met de préférence en œuvre des blocs 80, 90 de génération de signaux de drapeaux compacts, comme dans les exemples de réalisation des figures 8 et 9.

Sur la figure 8, un exemple de réalisation compacte du premier bloc 80 apte à générer un signal drapeau AND_flag indicateur d'opération logique ET est donné.

Ce bloc 80 est doté de transistors 81, 82, 83, 84, et peut être également pourvu, de manière optionnelle, d'un inverseur 85 en sortie duquel le signal drapeau peut être prélevé. On peut également réaliser un tel bloc avec une bascule en particulier une bascule D.

Une pré-charge d'un nœud Q est commandée par le signal d'initialisation RSTN appliqué sur la grille d'un transistor 81, par exemple de type PMOS. Le nœud Q, disposé ici en entrée d'un inverseur 85 peut être pré-chargé par exemple à un niveau logique '1' ce qui place la sortie de l'inverseur 85 à un niveau '0'. Le signal SA_OUT de sortie de l'amplificateur de détection est appliqué à une électrode d'un transistor 83, par exemple de type PMOS, dont la grille est commandée par le premier signal d'activation EN1.

Le signal SA_OUT prend une valeur donnée en fonction des informations logiques stockées dans les cellules sur lesquelles l'opération logique est réalisée, tandis que durant la première phase, le premier signal d'activation EN1, par exemple actif à l'état bas est déclenché pour rendre le transistor 83 passant et permettre de transférer le signal SA_OUT sur la grille d'un transistor 82, par exemple de type NMOS, dont la source est mise à un potentiel de masse GND. Un transistor 84 dont la grille est commandée par le premier signal d'activation EN1 sert de pré-charge pour la grille du transistor 82, par exemple de type NMOS connecté au nœud Q. Lorsque le signal SA_OUT est à un niveau logique '1', le nœud Q se décharge vers le potentiel de masse GND, ce qui a pour effet de mettre le signal drapeau AND_flag à un niveau '1'.

L'ajout ou non de l'inverseur 85 dépend du niveau logique que l'on souhaite conférer au signal drapeau AND_flag pour qu'il indique que toutes les cellules servant d'opérandes sont au même niveau logique, en particulier au niveau logique '1'. Dans l'exemple illustré, le signal SA_OUT de sortie reste à un niveau '0' lorsque tous les nœuds de stockage auxquels on accède sont à un niveau '1', ce qui se traduit en sortie du bloc 80 par un signal drapeau AND_flag restant au niveau logique '0'.

Sur la figure 9, un exemple de réalisation compacte du deuxième bloc 90 apte à générer un signal drapeau NOR_flag indicateur d'opération logique NON OU est représenté.

Le bloc 90 permettant de générer le signal drapeau NOR_flag peut être formé à l'aide de transistors 91, 92, 93, 94, et de manière optionnelle, d'un inverseur 95.

Les transistors 91, 92, 93, 94 ont ici un agencement semblable à celui des transistors 81, 82, 83, 84 du bloc 80. Le transistor 93 recevant le signal SA_OUT de l'amplificateur de détection est apte à transférer ou non le signal SA_OUT en fonction cette fois d'un deuxième signal d'activation EN2 déclenché lors de la deuxième phase Φ2.

Dans l'un ou l'autre des blocs 80, 90 décrits précédemment, le transistor 82 (resp. 92) sur la grille duquel on transfère le signal SA_OUT peut être d'un type différent de celui décrit précédemment, en particulier de type PMOS, tandis que le signal de réinitialisation RSTN peut être appliqué à un transistor 81, 91 de type NMOS, le nœud Q étant alors pré-chargé à un niveau logique '0'. Dans un tel cas, le transistor 84 (resp. 94) recevant le signal d'activation EN1 (resp. EN2) peut être également de type différent, en particulier de type PMOS et connecté cette fois à un potentiel VDD. Le transistor 83 (resp. 93) recevant le signal SA_OUT de sortie de l'amplificateur de détection peut être également de type différent et en particulier de type NMOS. Dans cette variante de configuration, lorsque le signal SA_OUT est au niveau '0', cela entraine la mise à un niveau logique '1' du signal drapeau AND_flag (resp. NOR_flag).

Dans l'un ou l'autre des exemples de réalisation d'étage de lecture et de portion de circuit permettant d'identifier une fonction logique NON OU, une fonction logique ET, une fonction logique OU EXCLUSIF. Il est également possible en variante de réaliser une identification de fonction OU, de fonction NON ET et de fonction NON OU EXCLUSIF, ces trois opérations étant des opérations complémentaires respectivement des opérations logiques précitées.

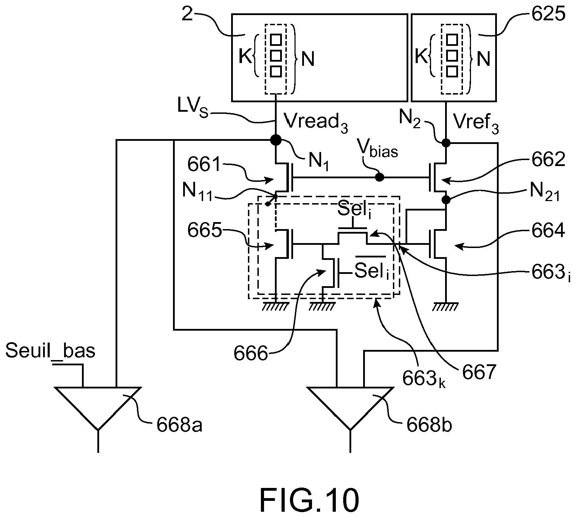

Un autre exemple de réalisation particulier d'étage de lecture, pour lire le résultat d'opérations IMC et en particulier d'opérations logiques à partir d'une ligne d'alimentation LVs (dans cet exemple la ligne d'alimentation basse) à laquelle il est couplé est illustré sur la figure 10.

Cet étage a la particularité de mettre en œuvre deux seuils de comparaison. Cela permet notamment de pouvoir détecter trois types d'opérations logiques sans nécessairement mettre en œuvre une activation des lignes de mots en deux phases telle que décrite précédemment. Ainsi, avec un tel étage de lecture, la mise en œuvre d'une séquence dans laquelle on active la première ligne de mot puis la deuxième ligne de mot ou dans laquelle on active la deuxième ligne de mot puis la première ligne de mot n'est pas nécessaire pour pouvoir détecter tous les types d'opérations logiques évoquées précédemment et en particulier pouvoir détecter une opération logique de type XOR ou XNOR.

Dans cet exemple de réalisation, un signal Vread3 est, consécutivement à l'activation de K cellules sur une colonne de N cellules, pris en pied de colonne à un nœud N₁ connecté à la ligne d'alimentation basse LVs. Le signal Vread3 en pied de colonne est dans cet exemple pris au drain d'un transistor 661 dont la source est reliée à un nœud N₁₁, auquel un ou plusieurs étages 663ₖ,...663ᵢ de structure semblable(s) à celle de l'étage 663ᵢ illustré sur la figure 10 sont connectés en parallèle. L'étage 663ᵢ comprend un transistor 665 dont le drain est connecté au nœud N₁₁ et la source connectée à la masse, ainsi que des transistors 666, 667 fonctionnant en interrupteur et reliés à la grille du transistor 665 comme expliqué en détail ci-après. Le signal Vread3 peut être comparé à un premier seuil prédéterminé fixe Seuil_bas, appliqué en entrée d'un premier comparateur 668a.

Un deuxième comparateur 668b et donc un deuxième seuil de comparaison sont également présents. Le deuxième comparateur 668b permet d'effectuer une comparaison entre d'une part le signal Vread3 qui dépend du courant en pied de colonne et d'autre part un signal de référence V_{ref3}, ce dernier étant quant à lui pris à un nœud N₂ relié à une colonne factice 625, autrement dit d'une colonne de cellules de référence dans laquelle un nombre K de cellules identique à celui utilisé dans la colonne de la matrice pour réaliser l'opération logique est activé. Le signal V_{ref3} est dans cet exemple pris sur le drain d'un transistor 662 dont la source est reliée, en un nœud N₂₁, à un transistor 664 monté en diode, la source du transistor 664 étant connectée à la masse. Les grilles des transistors 661 et 662 sont en outre reliées à une tension de polarisation Vbias et forment une structure cascode. Dans chaque étage, l'interrupteur 667 relie les grilles des transistors 665 et 664 et il est commandé par un signal de sélection Selᵢ. L'interrupteur 666 est placé entre la grille du transistor 665 et la masse et il est commandé par un signal complémentaire du signal Selᵢ. Par le biais des signaux de sélection il est possible de sélectionner ou non un étage, un étage étant sélectionné quand le transistor 667 est passant (reliant les grilles des transistors 665 et 664 formant un miroir de courant) et le transistor 666 non passant.

La comparaison au premier seuil Seuil_bas, réalisée par le premier comparateur 668a peut être prévue afin en particulier de réaliser une détection d'une valeur de courant minimale par le circuit de lecture. Cette détection de courant minimale, par ce premier comparateur permet de réaliser une première opération logique, d'un premier type AND ou NAND ou d'un second type NOR ou OR selon respectivement que ce sont les nœuds T ou F qui sont activés.

Avec une convention «inverseuse» du circuit de lecture, la sortie Z de l'opération réalisée par le premier comparateur 668a du circuit de lecture, recherchant un courant minimal, prendra une valeur « 1 » en sortie si le courant en pied de colonne est inférieur à un courant de référence minimal correspondant à une tension de référence Seuil-bas, et prendra la valeur « 0 » dans le cas inverse. Ainsi, on pourra avoir les valeurs suivantes en sortie du comparateur 668a « inverseur » (en prenant en outre la convention de cellule susmentionnée, valeur du nœud T = valeur de cellule):
- si les nœuds T sont activés :
   ∘ si toutes les cellules activées stockent une valeur logique '1', le courant en pied de colonne est minimal, Vread3 est inférieur à Seuil_bas et Z=1
   ∘ si au moins une des cellules activées stockent une valeur logique '0', le courant en pied de colonne n'est plus minimal, Vread3 est supérieur à Seuil_bas et Z=0
      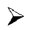 On réalise ainsi, dans cet exemple une opération logique AND entre les valeurs des opérandes sélectionnées.
- si les nœuds F sont activés :
   ∘ si toutes les cellules activées stockent une valeur logique '0', le courant en pied de colonne est minimal, Vread3 est inférieur à Seuil_bas et Z=1
   ∘ Si au moins une des cellules activées stockent une valeur logique '1', le courant en pied de colonne n'est plus minimal, Vread3 est supérieur à Seuil_bas et Z=0
      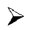 On réalise ainsi, dans cet exemple une opération logique NOR entre les valeurs des opérandes sélectionnées.

En prenant une convention inverse pour le premier comparateur du circuit de lecture, on réalise respectivement les opérations NAND et OR, en sélectionnant respectivement les nœuds T et F.

Le deuxième seuil peut être utilisé pour permettre de détecter une condition de courant maximal. Cette détection de courant maximale par ce deuxième comparateur permet de réaliser une première opération logique, d'un premier type AND ou NAND ou d'un second type NOR ou OR selon respectivement que ce sont les nœuds T ou F qui sont activés.

Avec une convention du circuit de lecture «non inverseuse», la sortie Z de l'opération réalisée par le deuxième comparateur 668b du circuit de lecture, recherchant un courant maximal, prendra une valeur « 1 » en sortie si le courant en pied de colonne est supérieur à un courant de référence maximal correspondant à une tension de référence Seuil-haut, et prendra la valeur « 0 » dans le cas inverse. Ainsi, on pourra avoir les valeurs suivantes en sortie du comparateur 668b « non inverseur » (en prenant en outre la convention de cellule susmentionnée, valeur du nœud T = valeur de cellule):
- si les nœuds T sont activés :
   ∘ si toutes les cellules activées stockent une valeur logique '0', le courant en pied de colonne est maximal, Vread3 est supérieur à Seuil_haut et Z=1
   ∘ si au moins une des cellules activées stockent une valeur logique '1', le courant en pied de colonne n'est plus maximal, Vread3 est inférieur à Seuil_haut et Z=0
      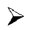 On réalise ainsi, dans cet exemple une opération logique NOR entre les valeurs des opérandes sélectionnées.
- si les nœuds F sont activés :
   ∘ si toutes les cellules activées stockent une valeur logique '1', le courant en pied de colonne est maximal, Vread3 est supérieur à Seuil_haut et Z=1
   ∘ si au moins une des cellules activées stockent une valeur logique '0', le courant en pied de colonne n'est plus maximal, Vread3 est inférieur à Seuil_haut et Z=0
      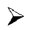 On réalise ainsi, dans cet exemple une opération logique AND entre les valeurs des opérandes sélectionnées.

Avec une convention inverse pour le deuxième comparateur du circuit de lecture, on réalise respectivement les opérations OR et NAND, en sélectionnant respectivement les nœuds T et F. Ainsi, en utilisant dans un même cycle temporel d'opération les deux comparateurs, il est possible de réaliser en même temps deux opérations logiques. Ainsi, si le premier comparateur est de type inverseur et le deuxième comparateur de type non-inverseur, on peut, comme décrit précédemment, réaliser simultanément respectivement des opérations logiques AND et NOR en sélectionnant les nœuds T, c'est-à-dire en activant les lignes de mots WL1 des lignes sélectionnées. En sélectionnant les nœuds F, par activation des lignes de mots WL2, les opérations réalisées par les premier et deuxième comparateurs en même temps sont respectivement des opérations NOR et AND (ce qui revient à « inverser » le rôle des comparateurs).

Comme précédemment décrit, en fonction du résultat de ces deux comparaisons et de l'ensemble des états de sortie respectifs des deux comparateurs 668a, 668b on peut détecter une condition de courant présentant une valeur « intermédiaire » (voir tableau susmentionné) et en déduire un résultat d'un troisième type d'opération logique, en particulier une opération XOR ou sa complémentaire, et ce, en un seul cycle de lecture.

Pour ajuster le deuxième seuil de comparaison de manière appropriée, et faire en sorte par exemple qu'il permette de détecter un courant maximal en pied de colonne correspondant à un cas où tous les bits stockés dans l'ensemble des K cellules sélectionnées ont la même valeur (par ex toutes égales à 1) tout en excluant un cas proche où au moins une des K cellules sélectionnées a une valeur différente (ex : toutes égales à 1 sauf une cellule), il est possible d'adapter au moment de la conception du circuit, les tailles respectives des transistors 661, 665, par rapport à celles des transistors 662, 664, ainsi que la tension d'offset du comparateur 668b.

On considère dans les deux modes de réalisation décrits ci-après qu'on a un unique étage 663 et donc un seul transistor 665 par exemple en permanence relié au transistor 664 (par leurs grilles).

Selon un mode de réalisation, on prévoit des transistors 664 et 665 de même taille. Ainsi, dans le cas où toutes les cellules sélectionnées sont conductrices, comme l'ensemble des cellules factices, un courant sensiblement identique circule dans chacune des branches (branche gauche avec les transistors 665 et 661 et branche droite avec les transistors 664 et 662) et les tensions Vread3 et Vref3 sont sensibles identiques. Ainsi, pour pouvoir correctement détecter un courant maximal en différentiant le cas où toutes les cellules conduisent et le cas où toutes les cellules sauf une conduisent, il est nécessaire d'introduire un offset en entrée du comparateur 668b, cet offset étant par exemple pris égal à la moitié de la différence de tension Vref3 entre les 2 cas que l'on souhaite discriminer.

Selon un autre mode de réalisation, les tailles des transistors 665 et 664 ne sont pas identiques et leur différence de taille permet d'introduire une différence de courant recopié, ou « offset de courant » dans le miroir de courant. Le comparateur 668b peut alors lui être sans offset d'entrée. Ainsi, pour pouvoir réaliser une distinction entre les 2 cas susmentionnés (toutes les cellules égales à '1' ou toutes les cellules moins une égales à '1') il faut que les tailles respectives des transistors 664 et 665 soient telles que les deux tensions Vread3 générées dans des 2 cas de figures soient respectivement supérieure et inférieure à la tension Vref3. En pratique, le transistor 665 sera un peu plus petit que le transistor 664 pour réaliser cette condition.

Dans les exemples décrits précédemment, un seul transistor 665 est utilisé. Dans les exemples ci-après, on prévoit d'utiliser plusieurs étages 663 afin de pouvoir sélectionner le nombre de transistors 665 que l'on souhaite mettre en parallèle entre le nœud N11 et la masse. Dans le cas où tous les transistors 665 sont activés, la taille cumulée équivalente de l'ensemble des transistors 665 correspond avantageusement à la taille d'un unique transistor 665 tel qu'utilisé dans les montages précédemment décrits.

Selon un mode de mise en œuvre, les étages 663ᵢ, 663ₖ agencés en parallèle et chacun connectés aux nœuds N₁₁ permettent, même après conception du circuit et lors de son utilisation, de déplacer le deuxième seuil de comparaison, en adaptant le nombre d'étages 663ᵢ, 663ₖ activés. On active un étage 663ᵢ par le biais de signaux de sélection complémentaires Selᵢ, S̅e̅l̅ₗ̅. Dans l'exemple de réalisation illustré sur la figure 10, un signal de sélection Selᵢ à l'état haut ('1') pour l'étage 663ᵢ, permet d'activer l'étage 663i ce qui se traduit en rendant respectivement passant le transistor interrupteur 667 et bloqué le transistor interrupteur 666. Les grilles respectives du transistor 665 et du transistor 664 monté en diode sont alors reliés entre elles. Lorsqu'un étage 663ₖ, est désactivé, le couple de signaux de sélection respectifs Selₖ, S̅e̅l̅k̅ de cet étage est inverse du couple Selᵢ, S̅e̅l̅ₗ̅, les signaux de sélection respectifs Selₖ, S̅e̅l̅k̅ étant prévus pour respectivement rendre bloqué le transistor interrupteur 667 et passant le transistor interrupteur 666.

Un circuit mémoire IMC tel que dans l'un ou l'autre des modes de réalisation décrits précédemment, outre le fait de pouvoir réaliser des opérations logiques, peut être utilisé pour réaliser des tests sur un groupe de cellules d'une colonne et indiquer si la proportion de cellules dans ladite colonne stockant une même donnée logique, par exemple un '1' logique, est supérieure ou non à au moins un seuil prédéterminé.

Un tel test permet par exemple de connaitre le contenu ('1' ou '0') prédominant dans une colonne de cellules mémoires et par exemple de savoir s'il y a plus 25%, ou 50% ou 75% de '1' contenu dans la colonne de cellules testées. Dans ce cas, la lecture du test peut être également réalisée sur une des lignes d'alimentation commune aux inverseurs de la cellule, par exemple la ligne d'alimentation basse. Un étage de lecture tel que dans l'exemple décrit précédemment en liaison avec la figure 10 se prête particulièrement à la mise en œuvre de tels tests de prédominance de contenu dans la mesure où il permet une comparaison d'un courant pris en pied de colonne sur la ligne d'alimentation LVs à un seuil de comparaison ajustable en fonction du nombre d'étages 663ᵢ,...,663ₖ activés.

Ainsi, dans le cas par exemple où les transistors 665 sont au nombre de 10, sont de même taille, par exemple égale à environ un dixième de la taille du transistor 664, il est possible de réaliser un test de « pourcentage » par pas de 10%. En sélectionnant la moitié des transistors 665, on teste si le courant en pied de colonne, est supérieur à environ la moitié du courant circulant dans les cellules factices. En effet, en ayant un miroir de courant qui fait un rapport 2 entre le courant provenant de la colonne factice et le courant tiré sur le nœud N1 via la recopie, les tensions Vread3 et Vref3 seront environ égales quand le courant en pied de colonne sélectionnée est environ deux fois moins élevé que celui circulant dans la colonne factice. Ainsi, si plus de 50% des cellules font circuler un courant, alors le résultat de la comparaison sera une première valeur en sortie du comparateur 668b et inversement. Le fonctionnement est transposable à tout ratio de courant dans le miroir de courant 665/664 défini par le nombre d'étages sélectionné.

En outre, selon un mode de réalisation, l'activation d'un nombre restreint d'étages, notamment d'un seul étage, peut éventuellement être utilisé pour réaliser une recherche de courant minimal en pied de colonne. Ceci constitue alors une méthode alternative de recherche de courant minimal ne nécessitant pas un deuxième comparateur, ou permettant de réaliser une opération redondante de recherche de courant minimal.

Dans l'un ou l'autre des exemples qui ont été décrits précédemment, pour effectuer une opération IMC et en particulier réaliser une opération logique, on vient lire le signal issu de la ligne d'alimentation basse LVs. On peut également adapter un dispositif précédemment décrit à une lecture sur la ligne d'alimentation haute LVd et donc, là encore, sur une ligne d'alimentation distincte des lignes de bits BL_{T}, BL_{F}. Pour cela l'étage de lecture est cette fois connecté à la ligne d'alimentation haute LVd. Dans ce cas, si l'on se place par exemple dans le cas particulier d'un étage de lecture tel qu'illustré sur la figure 1B, on peut prévoir de remplacer les transistors 166, 164 de type NMOS par des transistors de type PMOS partageant une électrode mise à un potentiel d'alimentation VDD. D'autres adaptations concernant la matrice mémoire notamment concernant les niveaux de tension utilisés permettant d'activer les cellules peuvent être alors également être prévus. Par exemple, au lieu de pré-charger des lignes de bits à une tension de Vdd, on peut alors utiliser une tension de précharge de Vss pour permettre de façon complémentaire un passage de courant entre une ligne de bits et le potentiel d'alimentation Vdd à travers le transistor PMOS de chaque cellule permettant de relier ces deux points, en fonction de la valeur mémorisée par chaque cellule.

## Revendications

1. Circuit mémoire adapté à mettre en œuvre des opérations logiques, le circuit mémoire comportant :
- une pluralité de cellules mémoires (Cᵢⱼ) agencées selon des lignes et des colonnes de cellules, chaque cellule mémoire étant dotée :
• d'un premier inverseur et d'un deuxième inverseur connectés de façon croisée entre un premier nœud de stockage (T, F) de donnée et un deuxième nœud de stockage (F, T) de donnée complémentaire, le premier inverseur et le deuxième inverseur étant connectés entre une première ligne d'alimentation (L_{VD}) commune au premier inverseur et au deuxième inverseur et une deuxième ligne d'alimentation (L_{VS}) commune au premier inverseur et au deuxième inverseur, la première ligne d'alimentation et la deuxième ligne d'alimentation étant partagées par des cellules d'une même colonne de cellules et,
• d'un premier transistor d'accès (TA_{T}, TA_{F}) au premier nœud de stockage contrôlé par un premier signal de commande véhiculé par une première ligne de mot (WL1, WL2), le premier transistor d'accès étant connecté à une première ligne de bit (BLT),
• d'un deuxième transistor d'accès (TA_{F}, TA_{T}) au deuxième nœud de stockage contrôlé par un deuxième signal de commande véhiculé par une deuxième ligne de mot (WL2, WL1), le deuxième transistor d'accès étant connecté à une deuxième ligne de bit (BLF),
le circuit mémoire comprenant en outre :
- un étage de commande (14) configuré pour activer au moins les premiers transistors d'accès ou au moins les deuxièmes transistors d'accès d'une pluralité de cellules d'une même colonne donnée (COLj) de cellules mémoires (Cᵢⱼ),
- au moins un étage de lecture (160) pour détecter, consécutivement à ladite activation et à partir d'un courant (I_{LVS}) ou d'un potentiel (V_{read}) issu de la deuxième ligne d'alimentation résultant (L_{VS}) de ladite colonne donnée (COLj) et consécutif à ladite activation, un signal représentatif du résultat d'une opération logique ayant pour opérandes des données stockées dans ladite pluralité de cellules.

2. Circuit mémoire selon la revendication 1, dans lequel le signal représentatif est détecté à partir d'un courant (I_{LVS}) issu de ladite deuxième ligne d'alimentation (L_{VS}), et dans lequel :
- lorsque ledit courant (I_{LVS}) est comparé à une valeur dite « minimale », ladite opération logique est l'un de premier et deuxième types d'opérations ;
- et/ou lorsque ledit courant (I_{LVS}) est comparé à une valeur dite « maximale », ladite opération logique est l'autre des premier et deuxième types d'opérations ;
le premier type d'opération correspondant à une opération **ET** ou **NON ET,** et le deuxième type d'opération correspondant à une opération **NON OU** ou **OU** ;
- et/ou lorsque ledit courant (I_{LVS}) a une valeur comprise entre ladite valeur minimale et ladite valeur maximale tout en étant différente de ladite valeur minimale et de ladite valeur maximale, ladite opération logique est d'un troisième type, en particulier de type **OU EXCLUSIF** ou de type **NON OU EXCLUSIF,**
la détection par l'étage de lecture (160) résultant d'au moins une comparaison entre d'une part ledit courant (I_{LVS}) ou une tension résultant d'une conversion dudit courant et d'autre part au moins un seuil de comparaison en courant ou en tension d'un bloc (268, 338a, 668b ; 368, 468) de comparaison dudit étage de lecture (160).

3. Circuit mémoire selon l'une des revendications 1 ou 2, dans lequel la détection dudit signal représentatif comprend une comparaison d'une tension provenant de la deuxième ligne d'alimentation (L_{VS}) à une tension de référence prédéterminée, en particulier une tension de référence produite par un bloc de circuit (451) programmable ou par une colonne (25, 525) factice de cellules,
de sorte à détecter, lorsque les premiers transistors d'accès sont activés, un état indiquant que les premiers nœuds reliés aux premiers transistors d'accès activés sont tous au niveau logique '1' ou sont tous au niveau logique '0', ou
de sorte à détecter, lorsque les deuxièmes transistors d'accès sont activés, un état indiquant que les deuxièmes nœuds reliés aux deuxièmes transistors d'accès activés sont tous au niveau logique '1' ou sont tous au niveau logique '0'.

4. Circuit mémoire selon l'une des revendications 1 à 3, comprenant en outre au moins une colonne factice (25) de cellules mémoires factices connectées à une ligne d'alimentation factice (Lref), ledit étage de lecture comprenant en outre au moins un comparateur (28) pour comparer le courant (I_{LVS}) ou le potentiel (V_{read}) issu de ladite deuxième ligne d'alimentation (LVS) de ladite colonne donnée à un signal de référence (Iₘₐₓ, V_{ref1}) issu de la ligne de basse factice (Lref) connectée à ladite colonne factice (25).

5. Circuit mémoire selon la revendication 4, dans lequel ladite pluralité de cellules compte K (avec K ≥ 2) cellules, l'étage de commande étant configuré pour, lors de ladite activation des transistors d'accès desdites K cellules, activer concomitamment K cellules de ladite colonne factice (25).

6. Circuit mémoire selon la revendications 1 à 5, dans lequel l'étage de lecture est doté d'un bloc d'identification (60) et dans lequel l'étage de lecture est configuré, en particulier au moyen d'un amplificateur de détection (31, 33), tel qu'un amplificateur de détection à une entrée ou de type différentiel, pour produire, en entrée du bloc d'identification (60), un signal donné (SA_OUT) dont l'état dépend d'une comparaison dudit courant (I_{LVS}) ou d'une tension résultant d'une conversion dudit courant à un seuil d'un bloc de comparaison (268 ; 368, 468), en particulier un comparateur ou un amplificateur de détection appartenant audit étage de lecture (160),
ledit bloc d'identification (60) étant configuré pour, en fonction de l'état dudit signal donné (SA_OUT), générer au moins un signal indicateur (AND_flag, NOR_flag, XOR_flag) d'un type d'opération logique parmi une pluralité d'opérations logiques déterminées, en particulier parmi une opération logique **OU EXCLUSIF,** une opération logique **ET,** une opération logique **NON OU,** ou parmi une opération logique **OU,** une opération logique **NON ET,** une opération logique **NON OU EXCUSIF.**

7. Circuit mémoire selon l'une des revendications 1 à 6, dans lequel ledit signal représentatif est détecté à partir d'un courant (I_{LVS}) issu de ladite deuxième ligne d'alimentation (L_{VS}), l'étage de lecture comprenant en outre une portion de circuit (163) pour convertir ledit courant en une tension de lecture (Vread), ladite tension de lecture étant transmise à un amplificateur de détection (368, 468), l'amplificateur de détection (368, 468) étant de type à une entrée ou bien l'amplificateur de détection (368, 468) étant de type différentiel et apte à comparer la tension de lecture (Vread) à une tension de référence (Vref).

8. Circuit mémoire selon la revendication 7, dans lequel l'amplificateur de détection (31, 33) est de type différentiel, la tension de référence (Vref) étant produite par une colonne factice (125) formée de cellules factices, ladite tension de référence (Vref) étant produite consécutivement à une activation par ledit étage de commande d'une cellule de ladite colonne factice (25).

9. Circuit mémoire selon l'une des revendications 1 à 8, dans lequel l'étage de commande est configuré pour, selon une première phase, activer les premiers transistors d'accès de ladite pluralité de cellules puis, selon une deuxième phase, activer lesdits deuxièmes transistors d'accès de ladite pluralité de cellules, l'étage de lecture étant configuré pour, lors de la première phase, détecter un courant issu de la deuxième ligne d'alimentation et provenant des premiers nœuds respectifs de ladite pluralité de cellules et pour lors de ladite deuxième phase, détecter un courant issu de la deuxième ligne d'alimentation et provenant des deuxièmes nœuds respectifs de ladite pluralité de cellules.

10. Circuit mémoire selon l'une des revendications 1 à 8, dans lequel l'étage de commande est configuré pour, selon une première phase, activer lesdits premiers transistors d'accès aux premiers nœuds respectifs de ladite pluralité de cellules, l'étage de lecture étant configuré pour, lors de la première phase, lorsqu'un signal issu de la deuxième ligne d'alimentation (LVS) indique que les premiers nœuds sont tous à un même niveau logique donné, en particulier un niveau logique '1' : produire un premier signal indicateur (AND_flag ou NAND_flag) d'un premier type d'opération logique, en particulier de type **ET** ou **NON ET.**

11. Circuit mémoire selon la revendication 10, dans lequel l'étage de commande est configuré pour, selon une deuxième phase consécutive à ladite première phase, activer lesdits deuxièmes transistors d'accès aux deuxièmes nœuds respectifs de ladite pluralité de cellules, l'étage de lecture étant configuré pour, lors de la deuxième phase, lorsqu'un signal issu de la ligne deuxième d'alimentation (LVS) indique que les deuxièmes nœuds sont tous à un niveau logique donné, en particulier un niveau logique '1': produire un deuxième signal indicateur (NOR_flag ou OR_flag) d'un deuxième type d'opération logique, en particulier de type **NON OU** ou **OU.**

12. Circuit mémoire selon la revendication 11, dans lequel l'étage de lecture est configuré en outre pour, lorsque ni le premier signal ni le deuxième signal n'a été produit à l'issue de la deuxième phase, produire un troisième signal (XOR_flag ou XNOR_flag) indicateur d'un troisième type d'opération logique, en particulier de type **OU EXCLUSIF** ou **NON OU EXCLUSIF.**

13. Circuit mémoire selon l'une des revendications 11 ou 12, dans lequel l'étage de lecture est doté d'un bloc d'identification (60), le bloc d'identification (60) comprenant un premier bloc verrou (80) apte, à partir d'un signal d'entrée (SA_OUT) dudit bloc d'identification, à produire et maintenir en sortie le premier signal indicateur (AND_flag) d'un premier type d'opération logique et un deuxième bloc verrou (90) apte, à partir du signal d'entrée (SA_OUT) dudit bloc d'identification, à produire et maintenir en sortie le deuxième signal indicateur (NOR_flag) d'un deuxième type d'opération logique, l'étage de commande étant configuré pour préalablement à la première phase,
- appliquer un signal de réinitialisation (RSTN) au premier bloc et au deuxième bloc verrou, puis,
- appliquer un premier signal d'activation (EN1) au premier bloc verrou (80) concomitamment à l'activation de premiers transistors d'accès,
- appliquer un deuxième signal d'activation (EN2) au deuxième bloc verrou (90) concomitamment à l'activation de deuxièmes transistors d'accès.

14. Circuit mémoire selon l'une des revendications 1 à 13, dans lequel l'étage de lecture est doté d'un multiplexeur (70) adapté pour recevoir :
- un premier signal indicateur (AND_flag) d'un premier type d'opération logique,
- un deuxième signal indicateur (NOR_flag) d'un deuxième type d'opération logique,
- un troisième signal indicateur (XOR_flag) d'un troisième type d'opération logique, et pour transmettre en fonction d'une instruction relative à une sélection d'opération logique parmi lesdites premier type, deuxième type et troisième type d'opérations logiques, l'un desdits premier signal indicateur ou deuxième signal indicateur ou troisième signal indicateur.

15. Circuit mémoire selon l'une des revendications 1 ou 2, dans lequel l'étage de commande est configuré pour, lors d'une phase donnée, activer les premiers transistors d'accès de ladite pluralité de cellules sans activer lesdits deuxièmes transistors d'accès aux deuxièmes nœuds respectifs de ladite pluralité de cellules ou activer lesdits deuxièmes transistors d'accès de ladite pluralité de cellules sans activer lesdits premiers transistors d'accès, la détection par l'étage de lecture (160) résultant, lors de ladite phase donnée d'une première comparaison entre un signal représentatif dudit courant (I_{LVS}) issu de la deuxième ligne d'alimentation et au moins un premier seuil d'un premier comparateur (668a) et lors de ladite même phase donnée d'une deuxième comparaison entre un signal représentatif dudit courant (I_{LVS}) issu de la deuxième ligne d'alimentation et au moins un deuxième seuil d'un deuxième comparateur (668b).
